(19) Europäisches Patentamt
European Patent Office
Office européen des brevets

(11) **EP 3 653 686 A1**

(12) **EUROPÄISCHE PATENTANMELDUNG**

(43) Veröffentlichungstag:
20.05.2020 Patentblatt 2020/21

(51) Int Cl.:
*C09K 11/02* [(2006.01)]    *C09K 11/56* [(2006.01)]
*C09K 11/88* [(2006.01)]    *H01L 33/50* [(2010.01)]
*B82Y 30/00* [(2011.01)]

(21) Anmeldenummer: 19210815.7

(22) Anmeldetag: 17.08.2016

(84) Benannte Vertragsstaaten:
AL AT BE BG CH CY CZ DE DK EE ES FI FR GB
GR HR HU IE IS IT LI LT LU LV MC MK MT NL NO
PL PT RO RS SE SI SK SM TR

(30) Priorität: 10.09.2015 EP 15184670

(62) Dokumentnummer(n) der früheren Anmeldung(en)
nach Art. 76 EPÜ:
**16753826.3 / 3 347 432**

(71) Anmelder: Merck Patent GmbH
64293 Darmstadt (DE)

(72) Erfinder:
• **Stenzel, Norbert**
**68623 LAMPERTHEIM (DE)**
• **Opolka, Andrea**
**18516 Suederholz (DE)**
• **Rieger, Bernhard**
**64839 Muenster-Altheim (DE)**
• **Tews, Stefan**
**17489 Greifswald (DE)**

Bemerkungen:
Diese Anmeldung ist am 22-11-2019 als
Teilanmeldung zu der unter INID-Code 62 erwähnten
Anmeldung eingereicht worden.

(54) **LICHTKONVERTIERENDES MATERIAL**

(57)    Die vorliegende Erfindung betrifft lichtkonvertierende Materialien, die Halbleiter-Nanopartikel und ein unaktiviertes kristallines Material umfassen, wobei sich die Halbleiter-Nanopartikel auf der Oberfläche des unaktivierten kristallinen Materials befinden. Ferner betrifft die vorliegende Erfindung die Verwendung des lichtkonvertierenden Materials in einer Lichtquelle. Weitere Gegenstände der vorliegenden Erfindung sind eine lichtkonvertierende Mischung, eine Lichtquelle, eine Beleuchtungseinheit, die das erfindungsgemäße lichtkonvertierende Material enthält, sowie ein Verfahren zur Herstellung der Lichtquelle.

Figur 2

EP 3 653 686 A1

**Beschreibung**

Gegenstand der Erfindung

Die vorliegende Erfindung betrifft ein lichtkonvertierendes Material, das ein unaktiviertes kristallines Material und Halbleiter-Nanopartikel (Quantenmaterialien), die sich auf der Oberfläche des unaktivierten kristallinen Materials befinden, umfasst, wobei das unaktivierte kristalline Material ein Matrixmaterial eines anorganischen Leuchtstoffes ist und die Oberfläche der Halbleiter-Nanopartikel mit einem oder mehreren Liganden beschichtet ist. Ferner betrifft die vorliegende Erfindung die Verwendung des lichtkonvertierenden Materials als Konversionsstoff zur teilweisen oder vollständigen Konversion von ultraviolettem und/oder blauem Licht in Licht mit einer größeren Wellenlänge. Ein weiterer Gegenstand der vorliegenden Erfindung betrifft eine lichtkonvertierende Mischung, eine Lichtquelle und eine Beleuchtungseinheit, die das erfindungsgemäße lichtkonvertierende Material enthält. Des Weiteren betrifft die vorliegende Erfindung ein Verfahren zur Herstellung einer Lichtquelle enthaltend das erfindungsgemäße lichtkonvertierende Material.

Hintergrund der Erfindung

Rund 20% des inländischen Energieverbrauchs entfällt auf die Erzeugung von Licht. Herkömmliche Glühlampen sind ineffizient und die effizientesten Leuchtstofflampen enthalten bis zu 10 mg Quecksilber. Festkörperbeleuchtungseinrichtungen, wie beispielsweise Leuchtdioden (LEDs), sind eine vielversprechende Alternative, da sie einen besseren Wirkungsgrad bei der Umwandlung von elektrischer Energie in Licht (Energieeffizienz), eine längere Lebensdauer und eine höhere mechanische Stabilität als herkömmliche Lichtquellen aufweisen. LEDs sind in vielfältigen Anwendungen verwendbar, darunter Anzeigen, Kfz- und Schilderbeleuchtung und Wohnungs- und Straßenbeleuchtung. Eine LED kann in Abhängigkeit von der zu ihrer Herstellung verwendeten anorganischen Halbleiterverbindung monochromatisches Licht in unterschiedlichen Bereichen des Spektrums emittieren. "Weißes" Licht, das für einen sehr großen Teil der Beleuchtungsindustrie erforderlich ist, lässt sich mit einer herkömmlichen LED jedoch nicht erzeugen. Derzeitige Lösungen für die Erzeugung von weißem Licht beinhalten entweder die Verwendung von drei oder mehr LEDs mit verschiedenen Farben (z.B. rot, grün und blau oder "RGB") oder die Verwendung einer Farbkonversionsschicht aus einem herkömmlichen Leuchtstoffmaterial (z.B. YAG:Ce) zur Erzeugung weißen Lichtes aus einer ultravioletten (UV) oder blauen Emission einer LED. So wird blaues Licht in Licht mit einer längeren Wellenlänge umgewandelt und die Kombination aus blauem und gelbem Licht wird von dem menschlichen Auge als weißes Licht wahrgenommen. Derartiges weißes Licht ist jedoch fast immer nicht ideal und hat in vielen Fällen unerwünschte oder unangenehme Eigenschaften, die Verbesserung oder Korrektur erfordern können. Der einfachere Aufbau von Konversions-LEDs richtet sich nach dem Massenmarkt von Beleuchtungseinrichtungen. Derzeit sind diese LED-Lampen noch deutlich teurer als herkömmliche Glühlampen und die meisten Fluoreszenzlampen und die im Handel erhältlichen weißen LEDs geben ein bläuliches, kaltweißes Licht mit schlechten Farbwiedergabeeigenschaften ab. Diese als schlecht wahrgenommene Qualität des weißen Lichts stammt von dem gelben Konversionsleuchtstoffmaterial YAG:Ce aufgrund der fehlenden Emission im grünen und roten Teil des Spektrums.

Für Anzeigen ist es wichtig, über drei oder mehr Grundfarben mit einer engen spektralen Halbwertsbreite (FWHM) zu verfügen, die man mit LEDs erhält (typische FWHM < 30 nm). Damit lässt sich ein großer Farbraum abdecken. "Farbraum" wird normalerweise als der Bereich der Farbarten definiert, der durch Mischen von drei Farben erhältlich ist. Die Lösung, drei oder mehr verschiedenfarbige LEDs zu verwenden, ist jedoch für viele Anwendungen zu kostspielig und aufwendig. Es ist daher wünschenswert, über eine Lichtquelle zu verfügen, die mit einer einzigen LED eine große Farbraumabdeckung ermöglicht, was durch schmalbandig emittierende Konversionsmittel realisiert werden kann. Ein Verfahren zur Bereitstellung von LEDs für eine Lichtquelle mit breitem Spektrum nutzt Leuchtstoffe, die das kurzwellige LED-Licht in Licht mit einer längeren Wellenlänge umwandeln. Beispielsweise kann ein Leuchtstoff, der Licht über einen breiten Bereich von grünen Wellenlängen emittiert, mit blauem Licht von einer LED angeregt werden, die ein schmales blaues Spektrum erzeugt.

Das durch den Leuchtstoff erzeugte grüne Licht wird dann als eine Komponente der weißen Lichtquelle verwendet. Durch Kombinieren mehrerer Leuchtstoffe kann man im Prinzip eine weiße Lichtquelle mit breitem Spektrum schaffen, vorausgesetzt die Effizienzen der Leuchtstoffe bei der Lichtumwandlung sind ausreichend hoch. Dieses würde zu verbesserten Farbwiedergabeeigenschaften führen. Weitere Einzelheiten finden sich in "Status and prospects for phosphor-based white LED Packaging", Z. Liu et al., Xiaobing Front. Optoelectron. China 2009, 2(2): 119-140.

Leider verfügt jedoch ein Lichtdesigner nicht über einen beliebigen Satz an Leuchtstoffen, aus denen er wählen kann. Es gibt nur eine begrenzte Anzahl von herkömmlichen, in LEDs einsetzbaren Leuchtstoffen, die Seltenerdelemente enthalten und die ausreichende Effizienzen bei der Lichtumwandlung aufweisen. Das Emissionsspektrum dieser Leuchtstoffe lässt sich nicht ohne weiteres ändern. Außerdem sind die Spektren insoweit weniger ideal, da das als Funktion der Wellenlänge emittierte Licht nicht konstant ist. Selbst durch Kombination von mehreren Leuchtstoffen erhält man daher keine optimale weiße Lichtquelle. Zusätzlich emittieren aktuell verwendete rote Leuchtstoffe Licht bis tief in den langwelligen roten Spektralbereich, was die Helligkeit derartiger LED und somit deren Effizienz zusätzlich senkt.

Die US-Patente 7,102,152, 7,495,383 und 7,318,651 offenbaren Vorrichtungen und Verfahren zur Emission von Licht, wobei sowohl Halbleiter-Nanopartikel in Form von Quantenpunkten (quantum dots - QDs) als auch Nichtquanten-Fluoreszenzmaterialien genutzt werden, um mindestens einen Teil des ursprünglichen von einer Lichtquelle der Vorrichtung emittierten Lichts in Licht mit längerer Wellenlänge umzuwandeln. QDs besitzen eine hohe Quantenausbeute und sie weisen ein schmales Emissionsspektrum mit einer zentralen Emissionswellenlänge, die über die Größe einstellbar ist, auf. Eine Kombination von sowohl QDs als auch Leuchtstoffen kann die Lichtqualität verbessern. QD-Zusätze können Verbesserungen bringen, haben aber den Nachteil einer hohen Eigenabsorption, d.h. sie absorbieren Licht, das emittiert wird, wenn sie selbst angeregt sind. Hierdurch wird die Gesamtenergieeffizienz der Lichtumwandlung reduziert. Zudem reabsorbieren QDs als auch kommerziell erhältliche Rotemitter ebenfalls die grüne Leuchtstoffemission, was zusätzlich zu einer Abnahme der Energieeffizienz und darüber hinaus zu einer Verschiebung des Emissionsspektrums führt, wodurch eine zielgerichtete Farbplanung erschwert wird. Darüber hinaus kann es bei der Verwendung von QD-Materialien und Leuchtstoffen bei der Herstellung der LED zu einer Entmischung kommen, wodurch eine homogene Verteilung der lichtkonvertierenden Materialien nicht mehr gewährleistet ist. Eine verminderte Energieeffizienz sowie eine unzureichende Kontrolle der gewünschten Farbwiedergabe sind die Folge.

Bei einigen Anwendungen sind Cluster mit dicht gepackten QDs erwünscht. Solche dicht gepackten QD-Cluster zeigen ein Phänomen, das unter dem Namen Fluoreszenz-Resonanzenergietransfer (FRET) bekannt ist, siehe z.B. Joseph R. Lakowicz, "Principles of Fluorescence Spectroscopy", 2. Auflage, Kluwer Academic / Plenum Publishers, New York, 1999, S. 367-443. FRET tritt im Verhältnis zwischen einem Donor-QD, der mit einer kürzeren (z.B. blaueren) Wellenlänge emittiert, zu einem Akzeptor-QD, der in direkter Nachbarschaft angeordnet ist und mit längerer Wellenlänge emittiert, auf. Es findet eine Dipol-Dipol-Wechselwirkung zwischen dem Dipolmoment des Donoremissionsübergangs und dem Dipolmoment des Akzeptorabsorptionsübergangs statt. Die Effizienz des FRET-Prozesses hängt von der spektralen Überlappung zwischen der Absorption des Donors und der Emission des Akzeptors ab. Der FRET-Abstand zwischen Quantenpunkten liegt typischerweise bei 10 nm oder weniger. Die Effizienz des FRET-Effekts ist sehr stark abhängig vom Abstand. FRET führt zu einer Farbänderung (Rotverschiebung) und zu Effizienzverlusten bei der Lichtumwandlung. Aus diesem Grund wurden in früheren Arbeiten Anstrengungen unternommen, die Clusterbildung von QDs in lichtkonvertierenden Materialien zu vermeiden.

Halbleiter-Nanopartikel sind eine Klasse von Nanomaterialien, deren physikalische Eigenschaften durch Einstellen der Teilchengröße, Zusammensetzung und Form über einen breiten Bereich hinweg eingestellt werden können. Insbesondere die Fluoreszenzemission zählt zu den Eigenschaften dieser Klasse, die von der Teilchengröße abhängig sind. Die Einstellbarkeit der Fluoreszenzemission beruht auf dem Quantenbegrenzungseffekt, wonach eine Verringerung der Teilchengröße zu einem "Teilchen im Kasten"-Verhalten führt, was zu einer Blauverschiebung der Bandlückenenergie und somit zur Lichtemission führt. So kann beispielsweise die Emission von CdSe-Nanopartikeln von 660 nm für Teilchen mit einem Durchmesser von ~ 6,5 nm auf 500 nm für Teilchen mit einem Durchmesser von ~ 2 nm eingestellt werden. Ein ähnliches Verhalten kann für andere Halbleiter-Nanopartikel erzielt werden, was dazu führt, dass ein breiter Spektralbereich vom ultravioletten (UV) Bereich (bei Verwendung von beispielsweise ZnSe oder CdS) über den sichtbaren (VIS) Bereich (bei Verwendung von beispielsweise CdSe oder InP) bis in den nahen Infrarot (NIR) Bereich (bei Verwendung von beispielsweise InAs) abgedeckt werden kann. Eine Änderung der Form der Nanopartikel ist bereits für mehrere Halbleitersysteme gezeigt worden, wobei insbesondere die Stäbchenform (rod shape) von Bedeutung ist. Nanostäbchen haben Eigenschaften, die von den Eigenschaften kugelförmiger Nanopartikel abweichen. Beispielsweise zeigen sie eine Emission, die entlang der Längsachse des Stäbchens polarisiert ist, während kugelförmige Nanopartikel eine unpolarisierte Emission aufweisen. Anisotrope (längliche) Nanopartikel wie Nanostäbchen (auch im Folgenden gelegentlich als "Stäbe" bezeichnet) eignen sich somit für eine polarisierte Emission (s. WO 2010/095140 A3). X. Peng et al. beschreibt in "Shape control of CdSe nanocrystals" in Nature, 2000, 404, 59-61 CdSe-Nanostäbchen, die in einem Polymer eingebettet sind und die auf einem Kolloid-basierten Halbleiterkern (ohne Schale) basieren. Von einzelnen Nanostäbchen geht hier fast eine vollständige Polarisation aus. T. Mokari und U. Banin beschreiben in "Synthesis andproperties of CdSe/ZnS rod/shell nanocrystals" in Chemistry of Materials 2003, 15 (20), 3955-3960 eine Verbesserung der Emission von Nanostäbchen, wenn eine Schale auf die Stabstruktur aufgebracht wird. D. V. Talapin et al. beschreibt in "Seeded Growth of Highly Luminescent CdSe/CdS Nanoheterostructures with Rod and Tetrapod Morphologies" in Nano Letters 2007, 7 (10), 2951-2959 eine Verbesserung der Quantenausbeute, die für Nanostäbchen-Partikel mit einer Ummantelung (Schale) erreicht wird. C. Carbone et al. beschreibt in "Synthesis and Micrometer-Scale Assembly of Colloidal CdSe/CdS Nanorods Prepared by a Seeled Growth Approach" in Nano Letters 2007, 7 (10), 2942-2950 ein Dipol-Emissionsmuster für ummantelte Nanostäbchen, was bedeutet, dass die Emission von der Mitte des Stabes anstelle von dessen Spitzen ausgeht. Darüber hinaus wurde gezeigt, dass Nanostäbchen vorteilhafte Eigenschaften hinsichtlich der optischen Verstärkung aufweisen, was deren Potential für die Verwendung als Lasermaterialien verdeutlicht (Banin et al., Adv. Mater., 2002, 14, 317). Für einzelne Nanostäbchen wurde ebenfalls gezeigt, dass sie ein einzigartiges Verhalten in externen elektrischen Feldern zeigen, da nämlich die Emission reversibel ein- und ausgeschaltet werden kann (Banin et al., Nano Letters, 2005, 5, 1581). Eine weitere attraktive Eigenschaft von kolloidalen Halbleiter-Nanopartikeln ist deren chemische Zugänglichkeit, die eine Verarbeitbarkeit dieser Materialien in unterschiedlicher Weise gestattet. Die Halbleiter-Nanopartikel können aus Lösung durch Spin-Coating oder Sprühbeschichtung in Form von dünnen Schichten aufgetragen werden oder in Kunststoffen eingebettet werden. Jan Ziegler et al. beschreiben in "Silica-Coated InP/ZnS Nanocrystals as Converter Material in White LEDs", Advanced Materials, Bd. 20, Nr. 21, 13. Oktober 2008, Seite 4068-4073, die Herstellung von Weiß-LEDs mit dem Zusatz einer Silicon-Verbundschicht, die ein lichtemittierendes Konversionsmaterial auf einem Hochleistungs-Blau-LED-Chip enthält.

Die Verwendung von Halbleiter-Nanopartikeln in LED-Anwendungen wurde unter anderem in US 2015/0014728 A1 beschrieben, die ein Leuchtstoff-Matrix-Verbundpulver betrifft, das in einer LED verwendet werden kann. Das Leuchtstoff-Matrix-Verbundpulver enthält eine Matrix und mehrere Leuchtstoffe oder Quantenpunkte mit einer Größe von 100 nm oder weniger, die in der Matrix dispergiert sind, wobei die Größe des Verbundpulvers 20 $\mu$m oder mehr beträgt und es eine bestimmte Oberflächenrauhigkeit aufweist. Das beschriebene Verbundpulver erfordert bereits bei seiner Herstellung eine genaue Einstellung der Mengenverhältnisse der Leuchtstoffe und Quantenpunkte, um das gewünschte Emissionsverhalten zu erzielen. Eine nachträgliche Anpassung der Mengenverhältnisse ist hingegen nicht möglich, was zu einer eingeschränkten Flexibilität in der Anwendbarkeit des Verbundpulvers bei der Herstellung von LEDs führt. Darüber hinaus hängt die Effizienz der Energiekonversion in starkem Maße von der Art und Menge der in der Matrix dispergierten Leuchtstoffmaterialien ab. Insbesondere, wenn die Menge der Leuchtstoffe und/oder der Quantenpunkte hoch ist, wird es schwierig, das Material zu sintern. Zudem steigt die Porosität an, was eine effiziente Bestrahlung mit Anregungslicht erschwert und die mechanische Festigkeit des Materials beeinträchtigt. Wenn jedoch die Menge der in der Matrix dispergierten Leuchtstoffmaterialien zu gering ist, wird es schwierig, eine ausreichende Lichtkonversion zu erzielen.

Angesichts der zahlreichen Mängel der bekannten oben genannten Lichtumwandlungsmaterialien, darunter die bekannte Kombinationen von QDs mit herkömmlichen Leuchtstoffen (Konversionsleuchtstoffen), besteht ein Bedarf an Halbleiter-Nanopartikel-Materialien und Zusammensetzungen, die solche Materialien mit herkömmlichen Leuchtstoffen enthalten, die keine derartigen Mängel aufweisen. Insbesondere besteht ein Bedarf an Kombinationen aus Halbleiter-Nanopartikeln und Konversionsleuchtstoffen mit geringer bis vernachlässigbarer Reabsorption und mit geringer Eigenabsorption, was zu einem hohen Wirkungsgrad bei der Konversion von Licht und zu einer verbesserten Steuerbarkeit des Farbraumes führt.

Es wäre daher wünschenswert, lichtkonvertierende Materialien auf der Basis von Halbleiter-Nanopartikeln zur Verfügung zu haben, die sich durch eine geringe Reabsorption und Eigenabsorption auszeichnen und somit die Energieeffizienz einer LED erhöhen. Ferner wäre es wünschenswert, lichtkonvertierende Materialien auf der Basis von Halbleiter-Nanopartikeln zur Verfügung zu haben, die sich durch eine verbesserte Mischbarkeit mit herkömmlichen Leuchtstoffen auszeichnen, so dass die oben beschriebenen Nachteile (z.B. verminderte Energieeffizienz und unzureichende Kontrolle der Farbwiedergabe), die sich aufgrund von Entmischungseffekten während der LED-Herstellung ergeben, vermieden werden.

Aufgabe der Erfindung

Aufgabe der vorliegenden Erfindung ist es daher, ein lichtkonvertierendes Material auf der Basis von Halbleiter-Nanopartikeln bereitzustellen, das die oben beschriebenen Nachteile aus dem Stand der Technik nicht aufweist. Insbesondere ist es eine Aufgabe der vorliegenden Erfindung, ein lichtkonvertierendes Material basierend auf Halbleiter-Nanopartikeln bereitzustellen, das eine verbesserte Mischbarkeit mit herkömmlichen Leuchtstoffen aufweist und dadurch eine effizientere Herstellung von LEDs ermöglicht, da Verluste aufgrund von Entmischungseffekten während des Mischens vermieden werden. Eine weitere Aufgabe der vorliegenden Erfindung ist die Bereitstellung eines lichtkonvertierenden Materials auf der Basis von Halbleiter-Nanopartikeln, das eine geringe Reabsorption im grünen Spektralbereich zeigt und somit aufgrund einer verminderten Doppelkonversion eine gesteigerte Effizient der LED sowie eine verbesserte Vorhersagbarkeit des LED-Spektrums ermöglicht. Ferner ist es Aufgabe der vorliegenden Erfindung ein lichtkonvertierendes Material basierend auf Halbleiter-Nanopartikeln bereitzustellen, das sich durch eine leichte Verarbeitbarkeit bei der Herstellung von LEDs auszeichnet und es LED-Herstellern ermöglicht, bereits vorhandene Ausrüstung und Maschinen für die Herstellung von LEDs zu verwenden. Darüber hinaus soll die vorliegenden Erfindung ein lichtkonvertierendes Material auf der Basis von Halbleiter-Nanopartikeln bereitstellen, das eine verbesserte und zielgerichtetere Einstellung der LED-Emission im Vergleich zu herkömmlichen Halbleiter-Nanopartikeln, die als Filme oder auf aktivierten Leuchtstoffen vorliegen, ermöglicht, was eine flexiblere Verwendung gestattet. Eine weitere Aufgabe der vorliegenden Erfindung ist die Bereitstellung eines lichtkonvertierenden Materials basierend auf Halbleiter-Nanopartikeln, das eine erhöhte Helligkeit der LED ermöglicht und sich darüber hinaus durch eine schmalbandige Emission auszeichnet, wodurch Energieverluste im langwelligen Spektralbereich vermieden werden und eine verbesserte Farbraumabdeckung in Anzeigen ermöglicht wird. Ferner soll das erfindungsgemäße lichtkonvertierende Material mit vorhandenen Beschichtungsverfahren, die bei der Herstellung von Leuchtstoffen verwendet werden, beschichtet werden können, wobei eine solche zusätzliche Barriereschicht nicht notwendig ist.

Beschreibung der Erfindung

Überraschenderweise wurde gefunden, dass die oben beschriebenen Aufgaben gelöst werden, wenn Halbleiter-Nanopartikel auf die Oberfläche eines unaktivierten kristallinen Materials aufgebracht werden, um dadurch ein lichtkonvertierendes Material zu erhalten. Ferner wurde überraschenderweise gefunden, dass unaktivierte kristalline Materialien mit Halbleiter-Nanopartikeln auf der Oberfläche eine ähnliche Korngrößen- und Dichtverteilung wie herkömmliche Leuchtstoffe aufweisen. Dies führt zu einer verbesserten Mischbarkeit solcher lichtkonvertierenden Materialien mit herkömmlichen Leuchtstoffen und ermöglicht eine effizientere Herstellung von LEDs, die sich durch verbesserte Leistungsdaten, wie Energieeffizienz, Helligkeit und Stabilität, auszeichnen.

Somit werden die oben erwähnten Aufgaben durch ein lichtkonvertierendes Material gelöst, das Halbleiter-Nanopartikel und ein unaktiviertes kristallines Material umfasst, wobei sich die Halbleiter-Nanopartikel auf der Oberfläche des unaktivierten kristallinen Materials befinden und das unaktivierte kristalline Material ein Matrixmaterial eines anorganischen Leuchtstoffes ist, dadurch gekennzeichnet, dass die Oberfläche der Halbleiter-Nanopartikel mit einem oder mehreren Liganden beschichtet ist.

Ausführungsformen der vorliegenden Erfindung betreffen lichtkonvertierende Materialien, die eine oder mehrere Arten eines unaktivierten kristallinen Materials und eine oder mehrere Art eines Halbleiter-Nanopartikels enthalten. Das resultierende lichtkonvertierende Material kann als Schüttgut, Pulvermaterial, dickes oder dünnes Schichtmaterial oder selbstragendes Material in Form eines Films vorliegen. Ferner kann es in einem Vergussmaterial eingebettet sein. Das lichtkonvertierende Material kann Zusatzmaterialien, wie beispielsweise Beschichtungsmaterialien, umfassen.

Die Erfinder haben überraschenderweise herausgefunden, dass Halbleiter-Nanopartikel verbesserte physikalische Eigenschaften aufweisen, wenn sie sich auf der Oberfläche von unaktivierten kristallinen Materialien befinden, was dazu führt, dass sie sich besser für die Kombination mit herkömmlichen Leuchtstoffen in Beleuchtungsanwendungen eignen. Insbesondere haben die Erfinder festgestellt, dass die Verwendung des erfindungsgemäßen lichtkonvertierenden Materials in Lichtquellen zu geringeren Reabsorptionseffekten und Selbstabsorptionseffekten der Halbleiter-Nanopartikel führt, was eine kontrollierte Farbeinstellung und eine hohe Effizienz ermöglicht. Darüber hinaus werden durch das erfindungsgemäße lichtkonvertierende Material der Fluoreszenz-Resonanzenergie-Transfer (FRET) sowie die damit verbundenen unerwünschten Konsequenzen unterdrückt. Halbleiter-Nanopartikel weisen eine sehr geringe Photolumineszenz-Selbstabsorption und eine sehr geringe Absorption der Emission herkömmlicher Leuchtstoffe auf und sind daher, insbesondere in optisch dichten Schichten, energieeffizienter als herkömmliche Leuchtstoffe. Ein lichtkonvertierendes Material der vorliegenden Erfindung zeichnet sich somit durch eine geringe Selbstabsorption und eine geringe Reabsorption aus.

Die vorliegende Erfindung stellt ferner eine lichtkonvertierende Mischung bereit, die eines oder mehrere der erfindungsgemäßen lichtkonvertierenden Materialien umfasst.

Das erfindungsgemäße lichtkonvertierende Material sowie die erfindungsgemäße lichtkonvertierende Mischung ermöglichen die teilweise oder vollständige Konversion von ultraviolettem und/oder blauem Licht in Licht mit einer größeren Wellenlänge, wie beispielsweise grünes oder rotes Licht.

Darüber hinaus stellt die vorliegende Erfindung eine Lichtquelle bereit, die mindestens eine Primärlichtquelle und mindestens ein erfindungsgemäßes lichtkonvertierendes Material oder mindestens eine erfindungsgemäße lichtkonvertierende Mischung enthält.

Die Lichtquelle der vorliegenden Erfindung kann in einer Beleuchtungseinheit zum Einsatz kommen.

Die vorliegende Erfindung stellt zudem ein Verfahren zur Herstellung der erfindungsgemäßen Lichtquelle bereit, wobei das erfindungsgemäße lichtkonvertierende Material oder die erfindungsgemäße lichtkonvertierende Mischung als Film durch Spin-Coating, Sprühbeschichtung oder in Form eines Films als Laminat auf die Primärlichtquelle oder ein Trägermaterial aufgetragen wird.

Bevorzugte Ausführungsformen der Erfindung werden in den abhängigen Ansprüchen beschrieben.

Beschreibung der Figuren

**Figur 1:** Absorptionsspektren der hergestellten lichtkonvertierenden Materialien aus den Beispielen 1 bis 4. M = Sr.

**Figur 2:** Relative spektrale Energieverteilung der Emission der hergestellten lichtkonvertierenden Materialien aus den Beispielen 1 bis 4. M = Sr.

**Figur 3:** Emissionsspektrum LED 1: roter QD ($\lambda_{max}$=635 nm) auf $Sr_3SiO_5$ kombiniert mit grünem QD ($\lambda_{max}$=543 nm) auf $Y_3Al_5O_{12}$ in einer blauen LED ($\lambda_{max}$=450 nm) bei Farbkoordinate x~0,31 und y~0,31; NTSC mit Standardfarbfilter ist 100%.

**Figur 4:** Emissionsspektrum LED 2: roter QD ($\lambda_{max}$=635 nm) auf $Sr_3SiO_5$ kombiniert mit grünem Silikatleuchtstoff ($\lambda_{max}$=520 nm) in einer blauen LED ($\lambda_{max}$=450 nm) bei Farbkoordinate x~0,31 und y~0,31; NTSC mit Standardfarbfilter ist 98%.

**Figur 5:** Emissionsspektrum LED 3: roter QD ($\lambda_{max}$=635nm) auf $Y_3Al_5O_{12}$ in einer Mischung mit grünem $Lu_3Al_5O_{12}$:Ce ($\lambda_{max}$=540 nm, CRI 85, gepunktete Linie) und in einer Mischung mit gelbem $Y_3Al_5O_{12}$:Ce ($\lambda_{max}$=560 nm, CRI 80, durchgezogene Linie).

Definitionen

Wie in der vorliegenden Anmeldung verwendet, bezeichnet der Begriff "lichtkonvertierendes Material" eine Kombination aus Halbleiter-Nanopartikeln mit einem unaktivierten kristallinen Material, wobei sich die Halbleiter-Nanopartikel auf der Oberfläche des unaktivierten kristallinen Materials befinden. Das lichtkonvertierende Material der vorliegenden Erfindung kann eine oder mehrere Arten von Halbleiter-Nanopartikeln umfassen und/oder eine oder mehrere Arten von unaktivierten kristallinen Materialien umfassen, wobei sich die Halbleiter-Nanopartikel auf der Oberfläche des unaktivierten kristallinen Materials bzw. der unaktivierten kristallinen Materialien befinden.

Wie in der vorliegenden Anmeldung verwendet, bezeichnet der Begriff "unaktiviertes kristallines Material" ein in Teilchenform vorliegendes anorganisches Material, das kristallin ist und keinen Aktivator, d.h. keine lichtkonvertierenden Zentren, besitzt. Das unaktivierte kristalline Material ist somit selbst weder lumineszierend noch fluoreszierend. Darüber hinaus besitzt es keine spezifische Eigenabsorption im sichtbaren Bereich und ist folglich farblos. Ferner ist das unaktivierte kristalline Material transparent. Das unaktivierte kristalline Material dient als Trägermaterial für die Halbleiter-Nanopartikel. Aufgrund der Farblosigkeit und Transparenz des unaktivierten kristallinen Materials kann Licht, das von einer Primärlichtquelle, von einem anderen Leuchtstoff oder einem anderen lichtkonvertierenden Material emittiert wird, ungehindert und verlustfrei das Material passieren, wodurch die Effizienz der Anwendung des erfindungsgemäßen lichtkonvertierenden Materials in einer LED gesteigert wird.

Wie in der vorliegenden Anmeldung verwendet, bezeichnen die Begriffe "Leuchtstoff" oder "Konversionsleuchtstoff", die hier als Synonyme verwendet werden, ein in Teilchenform vorliegendes fluoreszierendes anorganisches Material mit einem oder mehreren emittierenden Zentren. Die emittierenden Zentren entstehen durch Aktivatoren, gewöhnlicherweise Atome oder Ionen eines Seltenerdmetall-Elements, wie beispielsweise La, Ce, Pr, Nd, Pm, Sm, Eu, Gd, Tb, Dy, Ho, Er, Tm, Yb und Lu, und/oder Atome oder Ionen eines Übergangsmetall-Elements, wie beispielsweise Cr, Mn, Fe, Co, Ni, Cu, Ag, Au und Zn, und/oder Atome oder Ionen eines Hauptgruppenmetall-Elements, wie beispielsweise Na, Tl, Sn, Pb, Sb und Bi. Beispiele für Leuchtstoffe bzw. Konversionsleuchtstoffe umfassen Granat-basierte Leuchtstoffe, Leuchtstoffe auf Silikatbasis, Orthosilikatbasis, Thiogallatbasis, Sulfidbasis und Nitridbasis. Leuchtstoffmaterialien im Sinne der vorliegenden Erfindung weisen keinerlei Quantenbegrenzungseffekte auf. Solche nicht-quantenbegrenzte Leuchtstoffmaterialien können Leuchtstoffteilchen mit oder ohne Siliciumdioxid-Beschichtung sein. Unter einem Leuchtstoff oder Konversionsleuchtstoff im Sinne der vorliegenden Anmeldung wird ein Material verstanden, das in einem bestimmten Wellenlängenbereich des elektromagnetischen Spektrums, vorzugsweise im blauen oder im UV-Spektralbereich, Strahlung absorbiert und in einem anderen Wellenlängenbereich des elektromagnetischen Spektrums, vorzugsweise im violetten, blauen, grünen, gelben, orangen oder roten Spektralbereich sichtbares Licht emittiert. In diesem Zusammenhang ist auch der Begriff "strahlungsinduzierte Emissionseffizienz" zu verstehen, d. h. der Konversionsleuchtstoff absorbiert Strahlung in einem bestimmten Wellenlängenbereich und emittiert Strahlung in einem anderen Wellenlängenbereich mit einer bestimmten Effizienz. Unter dem Begriff "Verschiebung der Emissionswellenlänge" versteht man, dass ein Konversionsleuchtstoff im Vergleich zu einem anderen oder ähnlichen Konversionsleuchtstoff Licht bei einer anderen Wellenlänge emittiert, das heißt verschoben zu einer kleineren oder größeren Wellenlänge.

Der Begriff "Halbleiter-Nanopartikel" (Quantenmaterial) bezeichnet in der vorliegenden Anmeldung ein Nanoteilchen, das aus einem Halbleitermaterial besteht. Halbleiter-Nanopartikel sind beliebige diskrete Einheiten mit mindestens einer Dimension in Submikrometergröße, die in einigen Ausführungsformen kleiner als 100 nm ist und in einigen anderen Ausführungsformen als größte Abmessung (Länge) eine Größe von weniger als einem Mikrometer besitzt. In einigen anderen Ausführungsformen ist die Abmessung kleiner als 400 nm. Der Halbleiter-Nanopartikel kann jede beliebige symmetrische oder unsymmetrische geometrische Form aufweisen und nicht-einschränkende Beispiele möglicher Formen sind länglich, rund, elliptisch, pyramidal, u.s.w.. Ein spezifisches Beispiel für einen Halbleiter-Nanopartikel ist ein länglicher Nanopartikel, der auch als Nanostäbchen oder Nanostab bezeichnet wird und aus einem halbleitenden Material hergestellt ist. Weitere Halbleiter-Nanostäbchen, die verwendet werden können, sind solche mit einem Metall- oder Metalllegierungsbereich auf einem oder beiden Enden des jeweiligen Nanostäbchens. Beispiele solcher länglichen Halbleiter-Metall-Nanopartikel und deren Herstellung werden in der WO 2005075339 beschrieben, dessen Offenbarung hiermit durch Bezugnahme eingefügt wird. Andere mögliche Halbleiter-Metall-Nanopartikel werden in der WO 2006134599 gezeigt, dessen Offenbarung hiermit durch Bezugnahme eingefügt wird.

Ferner sind Halbleiter-Nanopartikel in einer Kern-Schale-Konfiguration oder einer Kern-Mehrschalen-Konfiguration bekannt. Es handelt sich hierbei um diskrete Halbleiter-Nanopartikel, die durch eine Heterostruktur gekennzeichnet sind, in der ein "Kern" aus einer Materialart mit einer "Schale" aus einem anderen Material bedeckt ist. In einigen Fällen lässt man die Schale auf dem Kern wachsen, der als "Impfkern" dient. Der Kern-Schale-Nanopartikel wird dann auch als "geimpfter" Nanopartikel bezeichnet. Der Ausdruck "Impfkern" oder "Kern" bezieht sich auf das innerste Halbleitermaterial, das in der Heterostruktur enthalten ist. Bekannte Halbleiter-Nanopartikel in Kern-Schale-Konfiguration werden beispielsweise in der EP 2 528 989 B1 gezeigt, deren Inhalt hiermit in der Gesamtheit durch Bezugnahme in die vorliegende Beschreibung aufgenommen wird. So sind beispielsweise punktförmige Halbleiter-Nanopartikel bekannt, bei denen eine kugelförmige Schale symmetrisch um einen kugelförmigen Kern angeordnet ist (sog. Quantenpunkte in Quantenpunkte). Darüber hinaus sind stäbchenförmige Halbleiter-Nanopartikel bekannt, bei denen ein kugelförmiger Kern asymmetrisch in einer länglichen stäbchenförmigen Schale angeordnet ist (sog. Quantenpunkte in Quantenstäbchen). Der Ausdruck Nanostäbchen bezeichnet einen Nanokristall mit einer stäbchenartigen Form, d.h. ein Nanokristall, der durch verstärktes Wachstum entlang einer ersten ("Längs-")Achse des Kristalls gebildet wird, während die Abmessungen entlang der beiden anderen Achsen sehr klein gehalten werden. Ein Nanostäbchen besitzt einen sehr kleinen Durchmesser (typischerweise weniger als 10 nm) und eine Länge, die im Bereich von etwa 6 nm bis etwa 500 nm liegen kann. Typischerweise weist der Kern eine nahezu kugelförmige Form auf. Es können jedoch auch Kerne mit unterschiedlichen Formen, wie beispielsweise Pseudopyramiden, Würfel-Oktaeder, Stäbchen und andere, verwendet werden. Typische Kerndurchmesser liegen im Bereich von etwa 1 nm bis etwa 20 nm. Bei symmetrischen punktförmigen Halbleiter-Nanopartikel in Kern-Schale-Konfiguration (Quantenpunkte in Quantenpunkte) ist der Partikel-Gesamtdurchmesser $d_2$ üblicherweise viel größer als der Kerndurchmesser $d_1$. Die Größenordnung von $d_2$ im Vergleich zu $d_1$ beeinflusst die optische Absorption des symmetrischen punktförmigen Halbleiter-Nanopartikels in Kern-Schale-Konfiguration. Bekanntermaßen kann ein Halbleiter-Nanopartikel in Kern-Schale-Konfiguration weitere äußere Schalen umfassen, die bessere optische und chemische Eigenschaften, wie eine höhere Quantenausbeute (QY) und bessere Haltbarkeit bereitstellen können. Der Halbleiter-Nanopartikel weist dann eine Kern-Mehrschalen-Konfiguration auf. Bei einem stäbchenförmigen Halbleiter-Nanopartikel in Kern-Mehrschalen-Konfiguration kann die Länge der ersten Schale im Allgemeinen im Bereich zwischen 10 nm und 200 nm und insbesondere zwischen 15 nm und 160 nm liegen. Die Dicken der ersten Schale in den anderen beiden Dimensionen (radiale Achse der Stäbchenform) kann im Bereich zwischen 1 nm und 10 nm liegen. Die Dicke der weiteren Schalen kann im Allgemeinen im Bereich zwischen 0,3 nm und 20 nm und insbesondere zwischen 0,5 nm und 10 nm liegen.

Andere Ausführungsformen sind z.B. Nanotetrapods (wie in US 8,062,421 B2 beschrieben), die einen Kern, bestehend aus einem ersten Material, und mindestens einen Arm, typischerweise aber vier weitere Arme, bestehend aus einem zweiten Material, umfassen, wobei sich der Kern und die Arme in ihrer Kristallstruktur unterscheiden. Solche Nanotetrapods weisen eine große Stokes-Verschiebung auf.

Der Begriff "Kernmaterial" bezeichnet das Material, das den Kern von Halbleiter-Nanopartikeln in einer Kern-Schale-Konfiguration oder Kern-Mehrschalen-Konfiguration bildet. Das Material kann ein Halbleiter der Gruppen II-VI, III-V, IV-VI oder I-III-VI$_2$ oder eine beliebige Kombination von einem oder mehreren davon sein. Beispielsweise kann das Kernmaterial ausgewählt sein aus der Gruppe bestehend aus CdS, CdSe, CdTe, ZnS, ZnSe, ZnTe, ZnO, GaAs, GaP, GaAs, GaSb, GaN, HgS, HgSe, HgTe, InAs, InP, InSb, AlAs, AlP, AlSb, $Cu_2S$, $Cu_2Se$, $CuGaS_2$, $CuGaSe_2$, $CuInS_2$, $CuInSe_2$, $Cu_2(InGa)S_4$, $AgInS_2$, $AgInSe_2$, $Cu_2(ZnSn)S_4$, Legierungen davon und Mischungen daraus.

Der Begriff "Schalenmaterial" bezieht sich auf das Halbleitermaterial, aus dem die Schale eines Halbleiter-Nanopartikels mit einer Kern-Schale-Konfiguration oder jede der einzelnen Schalen eines Halbleiter-Nanopartikels mit einer Kern-Mehrschalen-Konfiguration aufgebaut ist. Das Material kann ein Halbleiter der Gruppen II-VI, III-V, IV-VI oder I-III-VI$_2$ oder eine beliebige Kombination von einem oder mehreren davon sein. Beispielsweise kann das Schalenmaterial aus der Gruppe bestehend aus CdS, CdSe, CdTe, ZnS, ZnSe, ZnTe, ZnO, GaAs, GaP, GaAs, GaSb, GaN, HgS, HgSe, HgTe, InAs, InP, InSb, AlAs, AlP, AlSb, $Cu_2S$, $Cu_2Se$, $CuGaS_2$, $CuGaSe_2$, $CuInS_2$, $CuInSe_2$, $Cu_2(InGa)S_4$, $AgInS_2$, $AgInSe_2$, $Cu_2(ZnSn)S_4$, Legierungen davon und Mischungen daraus ausgewählt sein.

Der Begriff "Ligand" bezieht sich auf eine äußere Oberflächenbeschichtung der Halbleiter-Nanopartikel, die zu einem Passivierungseffekt führt und der Verhinderung einer Agglomeration oder Aggregation der Nanopartikel durch Überwindung der Van-der-Waals-Kräfte dient. Liganden, die allgemein verwendet werden können, sind: Phosphine und Phosphinoxide, wie Trioctylphosphinoxid (TOPO), Trioctylphosphin (TOP) oder Tributylphosphin (TBP); Phosphonsäuren, wie Dodecylphosphonsäure (DDPA), Tridecylphosphonsäure (TBPA), Octadecylphosphonsäure (ODPA) oder Hexylphosphonsäure (HPA); Amine, wie Dodecylamin (DDA), Tetradecylamin (TDA), Hexadecylamin (HDA) oder Octadecylamin (ODA); Imine, wie Polyethylenimin (PEI); Thiole, wie Hexadecanthiol oder Hexanthiol; Mercaptocarbonsäuren, wie Mercaptopropionsäure oder Mercaptoundecansäure; und andere Säuren, wie Myristinsäure, Palmitinsäure oder Ölsäure.

Der Begriff "Beschichtungsmaterial" bezeichnet ein Material, das eine Beschichtung auf der Oberfläche der Teilchen des lichtkonvertierenden Materials bildet. Der Begriff "Beschichtung" wird hier verwendet, um eine oder mehrere Schichten eines Materials, das auf einem anderen Material bereitgestellt ist und teilweise oder vollständig die äußere Oberfläche oder die Lösungsmitteln zugängliche Oberfläche des anderen Materials bedeckt, zu beschreiben. Aus dem verwendeten Wortlaut versteht es sich, dass die Beschichtung, die auf jedes einzelne Primärteilchen des lichtkonvertierenden Materials aufgebracht wird, zur Herstellung einer Vielzahl von verschiedenen beschichteten Primärteilchen, die voneinander getrennt sind, führt, anstatt zu einer Vielzahl von Teilchen, die zusammen in demselben Beschichtungsmaterial in Form einer einheitlichen Matrix enthalten oder eingeschlossen sind. Die Primärteilchen des lichtkonvertierenden Materials enthalten typischerweise mehrere Halbleiter-Nanopartikel. Das Material der Beschichtung (Beschichtungsmaterial) kann zumindest teilweise in die innere Struktur des Materials, das beschichtet worden ist, eindringen, sofern die Beschichtung als Barriere noch ausreichend Schutz gegenüber äußeren physikalischen Einflüssen oder den Durchtritt von möglicherweise schädlichen Substanzen, wie z. B. Sauerstoff, Feuchtigkeit und/oder freie Radikale, dient. Hierdurch wird die Stabilität des lichtkonvertierenden Materials erhöht, was zu einer verbesserten Haltbarkeit und Lebensdauer führt. Zusätzlich verleiht in einigen Ausführungsformen das Beschichtungsmaterial dem lichtkonvertierenden Material eine zusätzliche Funktionalität, wie etwa eine verringerte Empfindlichkeit gegenüber Wärme, eine reduzierte Lichtbrechung oder eine verbesserte Anhaftung der lichtkonvertierenden Materialien in Polymeren oder Vergussmaterialien. Ferner können Unebenheiten auf der Oberfläche der Teilchen des lichtkonvertierenden Materials durch den Auftrag eines oder mehrerer Beschichtungsmaterialien geglättet werden. Eine solche Oberflächenglättung ermöglicht eine gute Verarbeitbarkeit des lichtkonvertierenden Materials und reduziert unerwünschte optische Streueffekte des emittierten Lichts an der Oberfläche des Materials, was zu einer gesteigerten Effizienz führt.

Der Begriff "Vergussmaterial" bezieht sich auf ein lichtdurchlässiges Matrixmaterial, das die erfindungsgemäßen lichtkonvertierenden Materialien sowie die erfindungsgemäßen lichtkonvertierenden Mischungen einschließt. Das lichtdurchlässige Matrixmaterial kann ein Silicon, ein Polymer (das aus einem flüssigen oder halbfesten Vorläufermaterial wie einem Monomer gebildet ist), ein Epoxid, ein Glas oder ein Hybrid aus einem Silicon und Epoxid sein. Spezifische, jedoch nicht einschränkende Beispiele der Polymere beinhalten fluorierte Polymere, Polyacrylamid-Polymere, Polyacrylsäure-Polymere, Polyacrylnitril-Polymere, Polyanilin-Polymere, Polybenzophenon-Polymere, Poly(methyl-methycrylat)-Polymere, Silicon-Polymere, Aluminium-Polymere, Polybispheno-Polymere, Polybutadien-Polymere, Polydimethylsiloxan-Polymere, Polyethylen-Polymere, Polyisobutylen-Polymere, Polypropylen-Polymere, Polystyrol-Polymere, Polyvinyl-Polymere, Polyvinylbutyral-Polymere oder Perfluorcyclobutyl-Polymere. Silicone können Gele, wie beispielsweise Dow Corning® OE-6450, Elastomere, wie beispielsweise Dow Corning® OE-6520, Dow Corning® OE-6550, Dow Corning® OE-6630, und Harze, wie beispielsweise Dow Corning® OE-6635, Dow Corning® OE-6665, Nusil LS-6143 und andere Produkte von Nusil, Momentive RTV615, Momentive RTV656 und viele andere Produkte von anderen Herstellern, einschließen. Ferner kann das Vergussmaterial ein (Poly)silazan, wie beispielsweise ein modifiziertes organisches Polysilazan (MOPS) oder ein Perhydropolysilazan (PHPS) sein. Es ist bevorzugt, dass der Anteil des lichtkonvertierenden Materials bzw. der lichtkonvertierenden Mischung, bezogen auf das Vergussmaterial, im Bereich von 3 bis 80 Gew.-% liegt.

Bevorzugte Ausführungsformen der Erfindung

Gegenstand der vorliegenden Erfindung ist ein lichtkonvertierendes Material, das Halbleiter-Nanopartikel und ein unaktiviertes kristallines Material umfasst, wobei sich die Halbleiter-Nanopartikel auf der Oberfläche des unaktivierten kristallinen Materials befinden und das unaktivierte kristalline Material ein Matrixmaterial eines anorganischen Leuchtstoffes ist, dadurch gekennzeichnet, dass die Oberfläche der Halbleiter-Nanopartikel mit einem oder mehreren Liganden beschichtet ist.

Das unaktivierte kristalline Material ist farblos, was darauf zurückzuführen ist, dass das Material keinen Aktivator, d.h. keine emittierenden Zentren, besitzt. Hieraus folgt, dass das unaktivierte Material farblos und transparent ist, da es keine spezifische Eigenabsorption, Lumineszenz oder Fluoreszenz zeigt. Hierdurch kann Licht, das von einer Primärlichtquelle oder von einem anderen Leuchtstoff emittiert wird, ungehindert und verlustfrei das unaktivierte kristalline Material passieren und zu den Halbleiter-Nanopartikeln auf der Oberfläche gelangen, von denen es absorbiert, in Licht mit längerer Wellenlänge konvertiert und dann emittiert wird, wodurch die Effizienz bei Verwendung des erfindungsgemäßen lichtkonvertierenden Materials in einer LED gesteigert wird.

In der vorliegenden Erfindung dient das unaktivierte kristalline Material als Trägermaterial für die Halbleiter-Nanopartikel, die sich auf der Oberfläche des unaktivierten kristallinen Materials befinden. Die Halbleiter-Nanopartikel können hierbei statistisch oder in einer definierten Anordnung auf der Oberfläche des unaktivierten kristallinen Materials verteilt sein.

Das unaktivierte kristalline Material ist in der vorliegenden Erfindung hinsichtlich der chemischen Zusammensetzung nicht beschränkt. Ein unaktiviertes kristallines Material im Sinne der vorliegenden Erfindung ist jede kristalline anorganische Verbindung, die frei von emittierenden Zentren ist, die durch das Einfügen von Aktivatoren entstehen. Geeignete unaktivierte kristalline Materialien sind Wirtsgittermaterialien (Matrixmaterialien) von anorganischen Leuchtstoffen, die keine Aktivatoren und somit keine emittierenden Zentren aufweisen (unaktivierte Matrixmaterialien). Solche Matrixmaterialien von anorganischen Leuchtstoffen sind unaktiviert im Sinne der vorliegenden Erfindung, da sie keine spezifische Eigenabsorption zeigen und somit farblos sind. Sie eignen sich daher als Trägermaterialien für die Halbleiter-Nanopartikel. Für die vorliegende Erfindung kommen unaktivierte Matrixmaterialien der unterschiedlichsten Leuchtstoffe in Betracht, wie beispielsweise Matrixmaterialien von Metalloxid-Leuchtstoffen, Matrixmaterialien von Silikat- und Halosilikat-Leuchtstoffen, Matrixmaterialien von Phosphat- und Halophosphat-Leuchtstoffen, Matrixmaterialien von Borat- und Borosilikat-Leuchtstoffen, Matrixmaterialien von Aluminat-, Gallat- und Alumosilikat-Leuchtstoffen, Matrixmaterialien von Molybdat- und Wolframat-Leuchtstoffen, Matrixmaterialien von Sulfat-, Sulfid-, Selenid- und Tellurid-Leuchtstoffen, Matrixmaterialien von Nitrid- und Oxynitrid-Leuchtstoffen und Matrixmaterialien von SiAlON-Leuchtstoffen. Ferner kommen unaktivierte komplexe Metall-Sauerstoffverbindungen, unaktivierte Halogenverbindungen und unaktivierte Oxyverbindungen in Betracht, die keine Dotanden enthalten und die erforderliche Kristallinität aufweisen.

In einer bevorzugten Ausführungsform der vorliegenden Erfindung ist das unaktivierte kristalline Material ein Matrixmaterial eines anorganischen Leuchtstoffes, das aus unaktivierten kristallinen Metalloxiden, unaktivierten kristallinen Silikaten und Halosilikaten, unaktivierten kristallinen Phosphaten und Halophosphaten, unaktivierten kristallinen Boraten und Borosilikaten, unaktivierten kristallinen Aluminaten, Gallaten und Alumosilikaten, unaktivierten kristallinen Molybdaten und Wolframaten, unaktivierten kristallinen Sulfaten, Sulfiden, Seleniden und Telluriden, unaktivierten kristallinen Nitriden und Oxynitriden, unaktivierten kristallinen SiAlONen und anderen unaktivierten kristallinen Materialien, wie unaktivierte kristalline komplexe Metall-Sauerstoff-Verbindungen, unaktivierte kristalline Halogen-Verbindungen und unaktivierte kristalline Oxy-Verbindungen, wie vorzugsweise Oxysulfide oder Oxychloride, ausgewählt wird.

Bevorzugte unaktivierte kristalline komplexe Metall-Sauerstoff-Verbindungen sind unaktivierte Arsenate, unaktivierte Germanate, unaktivierte Halogermanate, unaktivierte Indate, unaktivierte Lanthanate, unaktivierte Niobate, unaktivierte Scandate, unaktivierte Stannate, unaktivierte Tantalate, unaktivierte Titanate, unaktivierte Vanadate, unaktivierte Halovanadate, unaktivierte Phosphovanadate, unaktivierte Yttrate und unaktivierte Zirconate.

In einer stärker bevorzugten Ausführungsform der vorliegenden Erfindung ist das unaktivierte kristalline Material ein unaktiviertes kristallines Aluminat, ein unaktiviertes kristallines Silikat oder Halosilikat oder ein unaktiviertes kristallines Titanat.

Beispiele von unaktivierten kristallinen Metalloxiden umfassen: $M^{2+}O$, $M^{3+}_2O_3$ und $M^{4+}O_2$, worin $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Ga, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; und $M^{4+}$ Ti, Zr, Ge, Sn und/oder Th ist.

Bevorzugte Beispiele unaktivierter kristalliner Metalloxide sind: $Al_2O_3$, $CaO$, $Ga_2O_3$, $La_2O_3$, $ThO_2$, $Y_2O_3$, $ZnO$, $(Y,Gd)_2O_3$ und $(Zn,Cd)O$.

Beispiele von unaktivierten kristallinen Silikaten oder Halosilikaten umfassen: $M^{2+}SiO_3$, $M^{2+}_2SiO_4$, $M^{2+}_2(Si,Ge)O_4$, $M^{3+}_2SiO_5$, $M^{3+}_2SiO_5$, $M^{3+}M^+SiO_4$, $M^{2+}Si_2O_5$, $M^{2+}_2Si_2O_6$, $M^{2+}_3Si_2O_7$, $M^{2+}_2M^+_2Si_2O_7$, $M^{3+}_2Si_2O_7$, $M^{2+}_4Si_2O_8$, $M^{2+}_2Si_3O_8$, $M^{2+}_3M^{3+}_2Si_3O_{12}$, $M^+M^{3+}M^{2+}_4Si_4O_{10}$, $M^+M^{2+}_4M^{3+}Si_4O_{14}$, $M^{2+}_3M^{3+}_2Si_6O_{18}$, $M^{3+}SiO_3X$, $M^{2+}_3SiO_4X_2$, $M^{2+}_5SiO_4X_6$, $M^+_2M^{2+}_2Si_4O_{10}X_2$, $M^{2+}_5Si_4O_{10}X_6$, $M^+_2SiX_6$, $M^{2+}_3SiO_3X_4$ und $M^{2+}_9(SiO_4)_4X_2$, worin $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; und X ein oder mehrere Halogene, vorzugsweise F, Cl, Br und/oder I, ist.

Bevorzugte Beispiele unaktivierter kristalliner Silikate und Halosilikate sind: $Ba_2(Mg,Sr)Si_2O_7$, $Ba_2SiO_4$, $(Ba,Sr)_2SiO_4$, $Ba_5SiO_4Br_6$, $BaSi_2O_5$, $BaSrMgSi_2O_7$, $Be_2SiO_4$, $Ca_2MgSi_2O_7$, $Ca_3MgSi_2O_8$, $Ca_3SiO_4Cl_2$, $CaMgSi_2O_6$, $CaSiO_3$, $(Ca,Mg)SiO_3$, $(Ca,Sr)_2SiO_4$, $Gd_2SiO_5$, $K_2SiF_6$, $LaSiO_3Cl$, $LiCeBa_4Si_4O_{14}$, $LiCeSrBa_3Si_4O_{14}$, $LiNa(Mg,Mn)_2Si_4O_{10}F_2$, $Lu_2Si_2O_7$, $Lu_2SiO_5$, $(Lu,Gd)_2SiO_5$, $Mg_2SiO_4$, $Mg_3SiO_3F_4$, $MgBa_3Si_2O_8$, $MgSiO_3$, $MgSr_3Si_2O_8$, $Sr_2MgSi_2O_7$, $Sr_2SiO_4$, $Sr_3Gd_2Si_6O_{18}$, $Sr_5Si_4O_{10}C_{16}$, $SrBaSiO_4$, $SrMgSi_2O_6$, $Y_2Si_2O_7$, $Y_2SiO_5$, $Zn_2(Si,Ge)O_4$, $Zn_2SiO_4$ und $(Zn,Be)_2SiO_4$.

Beispiele von unaktivierten kristallinen Phosphaten oder Halophosphaten umfassen: $M^{3+}PO_4$, $M^{2+}P_2O_6$, $M^{2+}_2P_2O_7$, $M^{+2}M^{2+}P^2O_7$, $M^{4+}P_2O_7$, $M^{2+}B_2P_2O_9$, $M^{2+}_6BP_5O_{20}$, $M^{2+}_3(PO_4)_2$, $M^+_3M^{3+}(PO_4)_2$, $M^{2+}_6(PO_4)_4$ und $M^{2+}_5(PO_4)_3X$, worin $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; $M^{4+}$ Ti, Zr, Ge und/oder Sn ist; und X ein oder mehrere Halogene, vorzugsweise F, Cl, Br und/oder I, ist.

Bevorzugte Beispiele unaktivierter kristalliner Phosphate und Halophosphate sind: $Ba_3(PO_4)_2$, $Ca_2Ba_3(PO_4)_3Cl$, $Ca_2P_2O_7$, $Ca_3(PO_4)_2$, $(Ca,Sr)_3(PO_4)_2$, $(Ca,Zn,Mg)_3(PO_4)_2$, $Ca_5(PO_4)_3(F,Cl)$, $Ca_5(PO_4)_3Cl$, $Ca_5(PO_4)_3F$, $CaB_2P_2O_9$, $CaP_2O_6$, $CaSr_2(PO_4)_2$, $LaPO_4$, $(La,Ce,Tb)PO_4$, $Li_2CaP_2O_7$, $LuPO_4$, $Mg_3Ca_3(PO_4)_4$, $MgBa_2(PO_4)_2$, $MgBaP_2O_7$, $MgCaP_2O_7$, $MgSr_5(PO_4)_4$, $MgSrP_2O_7$, $Na_3Ce(PO_4)_2$, $Sr_2P_2O_7$, $Sr_3(PO_4)_2$, $Sr_5(PO_4)_3Cl$, $Sr_5(PO_4)_3F$, $Sr_6BP_5O_{20}$, $YPO_4$, $Zn_3(PO_4)_2$, $Zn_3(PO_4)_2$, $ZnMg_2(PO_4)_2$, und $(Zn,Mg)_3(PO_4)_2$.

Beispiele von unaktivierten kristallinen Boraten, Haloboraten oder Borosilikaten umfassen: $M^{3+}BO_3$, $M^{2+}B_2O_4$, $M^{2+}_2B_2O_5$, $M^{3+}_2B_2O_6$, $M^{3+}B_3O_6$, $M^{2+}B_6O_{10}$, $M^{2+}M^{3+}BO_4$, $M^{2+}M^{3+}B_3O_7$, $M^{2+}B_4O_7$, $M^{2+}_3M^{3+}_2B_4O_{12}$, $M^{3+}_4B_4O_{12}$, $M^{3+}M^{2+}B_5O_{10}$, $M^{2+}_2B_6O_{11}$, $M^{2+}B_8O_{13}$, $M^{2+}_2B_5O_9X$, $M^{2+}_2M^{3+}_2BO_{6.5}$, $M^{2+}_5B_2SiO_{10}$, worin $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Ga, In, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; und X ein oder mehrere Halogene, vorzugsweise F, Cl, Br und/oder I, ist.

Bevorzugte Beispiele unaktivierter kristalliner Borate und Borosilikate sind: $Ca_2B_2O_5$, $Ca_2B_5O_9Br$, $Ca_2B_5O_9Cl$, $Ca_2La_2BO_{6,5}$, $Ca_5B_2SiO_{10}$, $CaB_2O_4$, $CaLaB_3O_7$, $CaLaBO_4$, $CaYBO_4$, $Cd_2B_6O_{11}$, $GdMgB_5O_{10}$, $InBO_3$, $LaAl_3B4O_{12}$, $LaAlB_2O_6$, $LaB_3O_6$, $LaBO_3$, $MgB_2O_4$, $MgYBO_4$, $ScBO_3$, $Sr_2B_5O_9Cl$, $SrB_4O_7$, $SrB_8O_{13}$, $YAl_3B_4O_{12}$, $YBO_3$, $(Y,Gd)BO_3$ und $ZnB_2O_4$, $SrO \cdot 3B_2O_3$.

Beispiele von unaktivierten kristallinen Aluminaten, Gallaten oder Alumosilikaten umfassen: $M^+AlO_2$, $M^{3+}AlO_3$, $M^{2+}M^{3+}AlO_4$, $M^{2+}Al_2O_4$, $M^{2+}Al_4O_7$, $M^+Al_5O_8$, $M^{3+}_4Al_2O_9$, $M^{3+}_3Al_5O_{12}$, $M^+Al_{11}O_{17}$, $M^{2+}_2Al_{10}O_{17}$, $M^{3+}_3Al_5O_{12}$, $M^{3+}_3(Al,Ga)_5O_{12}$, $M^{3+}_3Sc_2Al_3O_{12}$, $M^{2+}_2Al_6O_{11}$, $M^{2+}Al_8O_{13}$, $M^{2+}M^{3+}Al_{11}O_{19}$, $M^{2+}Al_{12}O_{19}$, $M^{2+}_4Al_{14}O_{25}$, $M^{2+}_3Al_{16}O_{27}$, $M^{2+}Ga_2O_4$, $M^{2+}Ga_4O_7$, $M^{3+}_3Ga_5O_{12}$, $M^+Ga_{11}O_{17}$, $M^{2+}Ga_{12}O_{19}$, $M^+_2M^{2+}_3Al_2Si_2O_{10}$ und $M^{2+}_3Al_2Si_3O_{12}$, worin $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; und X ein oder mehrere Halogene, vorzugsweise F, Cl, Br und/oder I, ist.

Bevorzugte Beispiele unaktivierter kristalliner Aluminate, Gallate und Alumosilikate sind: $BaAl_{12}O_{19}$, $BaAl_8O_{13}$, $BaMgAl_{10}O_{17}$, $CaAl_2O_4$, $CaAl_4O_7$, $(Ca,Ba)Al_{12}O_{19}$, $CaGa_2O_4$, $CaGa_4O_7$, $CeMgAl_{11}O_{19}$, $Gd_3Ga_5O_{12}$, $Gd_3Sc_2Al_3O_{12}$, $GdAlO_3$, $KAl_{11}O_{17}$, $KGa_{11}O_{17}$, $LaAlO_3$, $LaMgAl_{11}O_{19}$, $LiAl_5O_8$, $LiAlO_2$, $LiAlO_2$, $Lu_3Al_5O_{12}$, $LuAlO_3$, $(Lu,Y)AlO_3$, $MgAl_2O_4$, $MgGa_2O_4$, $MgSrAl_{10}O_{17}$, $Sr_2Al_6O_{11}$, $Sr_4Al_{14}O_{25}$, $SrAl_{12}O_{19}$, $SrAl_2O_4$, $SrAl_4O_7$, $SrGa_{12}O_{19}$, $SrGa_2O_4$, $Tb_3Al_5O_{12}$, $Y_3(Al,Ga)_5O_{12}$, $(Y,Gd)_3Al_5O_{12}$, $Y_3Al_5O_{12}$, $Y_4Al_2O_9$, $YAlO_3$, $ZnAl_2O_4$ und $ZnGa_2O_4$.

Beispiele von unaktivierten kristallinen Molybdaten oder Wolframaten umfassen: $M^{2+}MoO_4$, $M^+M^{3+}Mo_2O_8$, $M^{2+}WO_4$, $M^{2+}_3WO_6$, $M^{3+}_2W_3O_{12}$, $M^+M^{3+}W_2O_8$, worin $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; und X ein oder mehrere Halogene, vorzugsweise F, Cl, Br und/oder I, ist.

Bevorzugte Beispiele unaktivierter kristalliner Molybdate und Wolframate sind: $Ba_3WO_6$, $Ca_3WO_6$, $CaMoO_4$, $CaWO_4$, $CdWO_4$, $La_2W_3O_{12}$, $LiEuMo_2O_8$, $MgWO_4$, $Sr_3WO_6$, $SrMoO_4$, $Y_2W_3O_{12}$ und $ZnWO_4$.

Beispiele von unaktivierten kristallinen komplexen Metall-Sauerstoff-Verbindungen umfassen: $M^{3+}AsO_4$, $M^{2+}_{13}As_2O_{18}$, $M^{2+}GeO_3$, $M^{2+}_2GeO_4$, $M^{2+}_4GeO_6$, $M^{2+}_4(Ge,Sn)O_6$, $M^{2+}_2Ge_2O_6$, $M^{3+}_4Ge_3O_{12}$, $M^{2+}_5GeO_4X_6$, $M^{2+}_8Ge_2O_{11}X_2$, $M^+InO_2$, $M^{2+}In_2O_4$, $M^+LaO_2$, $M^{2+}La_4O_7$, $M^{3+}NbO_4$, $M^{2+}Sc_2O_4$, $M^{2+}_2SnO_4$, $M^{3+}TaO_4$, $M^{2+}TiO_3$, $M^{2+}_2TiO_4$, $M^+_2M^{3+}_2Ti_3O_{10}$, $M^{2+}_5(VO_4)_3X$, $M^{3+}VO_4$, $M^{3+}(V,P)O_4$, $M^+YO_2$, $M^{2+}ZrO_3$, $M^{2+}_2ZrO_4$ und $M^{2+}M^{3+}_2ZrO_6$, worin $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La, Bi und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; $M^{4+}$ Ti, Zr, Ge und/oder Sn ist; und X ein oder mehrere Halogene, vorzugsweise F, Cl, Br und/oder I, ist.

Bevorzugte Beispiele unaktivierter kristalliner komplexer Metall-Sauerstoff-Verbindungen sind: $Ba_5GeO_4Br_6$, $Bi_4Ge_3O_{12}$, $Ca_5(VO_4)_3Cl$, $CaGeO_3$, $CaLa_4O_7$, $CaSc_2O_4$, $CaTiO_3$, $CaY_2ZrCO_6$, $GdNbO_4$, $GdTaO_4$, $K_2La_2Ti_3O_{10}$, $LaAsO_4$, $LaVO_4$, $LiInO_2$, $LiLaO_2$, $LuTaO_4$, $Mg_{13}As_2O_{18}$, $Mg_2SnO_4$, $Mg_2TiO_4$, $Mg_4(Ge,Sn)O_6$, $Mg_4GeO_6$, $Mg_8Ge_2O_{11}F_2$, $NaYO_2$, $SrTiO_3$, $Y(V,P)O_4$, $YAsO_4$, $YTaO_4$, $YVO_4$ und $Zn_2GeO_4$.

Beispiele von unaktivierten kristallinen Sulfaten, Sulfiden, Seleniden oder Telluriden umfassen: $M^{2+}SO_4$, $M^{2+}_2(SO_4)_2$, $M^{2+}_3(SO_4)_3$, $M^{3+}_2(SO_4)_3$, $M^{2+}S$, $M^{2+}(S,Te)$, $M^{2+}Se$, $M^{2+}Te$, $M^{2+}Ga_2S_4$, $M^{2+}Ba_2S_3$ und $M^{2+}Al_2S_4$, worin $M^{2+}$ Zn, Fe, Co, Ni, Cd, Cu und/oder ein oder mehrere Erdalkalimetalle, vorzugsweise Be, Mg, Ca, Sr und/oder Ba, ist; und $M^{3+}$ Al, Sc, Y, La, und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist.

Bevorzugte Beispiele unaktivierter kristalliner Sulfate, Sulfide, Selenide und Telluride sind: $CaGa_2S_4$, $CaS$, $CaSO_4$, $CdS$, $Mg_2Ca(SO_4)_3$, $Mg_2Sr(SO_4)_3$, $MgBa(SO_4)_2$, $MgS$, $MgSO_4$, $SrAl_2S_4$, $SrGa_2S_4$, $SrS$, $SrSO_4$, $Zn(S,Te)$, $ZnBa_2S_3$, $ZnGa_2S_4$, $ZnS$, $(Zn,Cd)S$ und $ZnSe$.

Beispiele von unaktivierten kristallinen Halogen- oder Oxy-Verbindungen umfassen: $M^+X$, $M^{2+}X_2$, $M^{3+}X_3$, $M^+M^{2+}X_3$, $M^+M^{3+}X_4$, $M^{2+}M^{3+}_2X_8$, $M^+M^{3+}_3X_{10}$, $M^{3+}OX$, $M^{2+}_8M^{4+}_2O_{11}X_2$ und $M^{3+}_2O_2S$, worin $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La, und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; und X ein oder mehrere Halogene, vorzugsweise F, Cl, Br und/oder I, ist.

Bevorzugte Beispiele unaktivierter kristalliner Halogen-Verbindungen sind: $BaBr_2$, $BaCl_2$, $BaF_2$, $(Ba,Sr)F_2$, $BaFBr$, $BaFCl$, $BaY_2F_8$, $CaBr_2$ in $SiO_2$, $CaCl_2$ in $SiO_2$, $CaF_2$, $CaI_2$ in $SiO_2$, $CeF_3$, $CsF$, $CsI$, $KMgF_3$, $KY_3F_{10}$, $LaBr_3$, $LaCl_3$, $LaF_3$, $LiAlF_4$, $LiYF_4$, $MgF_2$, $NaI$, $NaYF_4$, $RbBr$, $Sr(Cl,Br,I)_2$ in $SiO_2$, $SrCl_2$ in $SiO_2$, $SrF_2$, $YF_3$, $ZnF_2$ und $(Zn,Mg)F_2$.

Bevorzugte Beispiele unaktivierter kristalliner Oxy-Verbindungen sind Oxysulfide und Oxychloride, ausgewählt aus: $Gd_2O_2S$, $La_2O_2S$, $LaOBr$, $LaOCl$, $LaOF$, $Y_2O_2S$, $YOBr$, $YOCl$ und $YOF$.

Beispiele von unaktivierten kristallinen Nitriden, Oxynitriden oder SiAlONen umfassen: $M^{3+}N$, $M^{2+}Si_2O_2N_2$,

$M^{2+}_2Si_5N_8$, $M^{3+}_3Si_6N_{11}$, $M^{2+}AlSiN_3$, $\alpha$-Sialone und $\beta$-Sialone, worin $M^{2+}$ Zn, Fe, Co, Ni, Cd, Cu und/oder ein oder mehrere Erdalkalimetalle, vorzugsweise Be, Mg, Ca, Sr und/oder Ba, ist; und $M^{3+}$ Al, Ga, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist.

Bevorzugte Beispiele unaktivierter kristalliner Nitride und Oxynitride sind: $Ba_2Si_5N_8$, $Ca_2Si_5N_8$, $CaAlSiN_3$, $(Ca,Sr)AlSiN_3$, GaN, $La_3Si_6N_{11}$, $Sr_2Si_5N_8$ und $(Sr,Ba)Si_2N_2O_2$.

Bevorzugte unaktivierte kristalline SiAlONe sind: $\alpha$-Sialone und $\beta$-Sialone.

Die genannten Beispiele der unaktivierten kristallinen Materialien dienen alleine der Veranschaulichung und sind hinsichtlich des Umfangs und des Schutzbereichs der vorliegenden Erfindung in keinster Weise als einschränkend zu verstehen.

Halbleiter-Nanopartikel, die in dem lichtkonvertierenden Material der vorliegenden Erfindung verwendet werden können, sind Halbleitermaterialien in Submikrometergröße, die in der Lage sind, Licht mit einer bestimmten Wellenlänge zu emittieren, wenn sie mit einer optischen Anregungsstrahlung mit einem anderen (kürzeren) Wellenlängenbereich bestrahlt werden. Halbleiter-Nanopartikel werden häufig auch als Quantenmaterialien bezeichnet. Das von Quantenmaterialien emittierte Licht zeichnet sich durch einen sehr engen Frequenzbereich (monochromatisches Licht) aus.

In einer bevorzugten Ausführungsform der vorliegenden Erfindung bestehen die Halbleiter-Nanopartikel aus mindestens zwei verschiedenen Halbleitermaterialien, die als Legierung oder in einer Kern-Schale-Konfiguration bzw. Kern-Mehrschalen-Konfiguration mit mindestens zwei Schalen vorliegen, wobei der Kern entweder ein Halbleitermaterial oder eine Legierung aus mindestens zwei verschiedenen Halbleitermaterialien enthält und die Schale(n) unabhängig ein Halbleitermaterial oder eine Legierung aus mindestens zwei verschiedenen Halbleitermaterialien enthalten, wobei wahlweise ein Konzentrationsgradient innerhalb des Kerns und/oder der Schale(n) und/oder zwischen dem Kern und/oder den Schale(n) vorliegen kann. In einer stärker bevorzugten Ausführungsform sind die Halbleitermaterialien oder die Legierungen aus mindenstens zwei verschiedenen Halbleitermaterialien im Kern und der benachbartem Schale und/oder in benachbarten Schalen verschieden.

Wie bereits zuvor beschrieben, werden die Halbleiter-Nanopartikel, die sich für die Zwecke der vorliegenden Erfindung eignen, aus Halbleitermaterialien hergestellt. Mögliche Materialzusammensetzungen der für die vorliegende Erfindung geeigneten Halbleiter-Nanopartikel werden in der WO 2010/095140 A3 und WO 2011/092646 A2 beschrieben, deren Inhalte hiermit unter Bezugnahme in die vorliegende Anmeldung aufgenommen werden. Die Halbleitermaterialien werden vorzugsweise ausgewählt aus Gruppe II-VI-Halbleitern, Gruppe III-V-Halbleitern, Gruppe IV-VI-Halbleitern, Gruppe $I\text{-}III\text{-}VI_2$-Halbleitern sowie aus Legierungen und/oder Kombinationen dieser Halbleiter, wobei die Halbleitermaterialien wahlweise mit einem oder mehreren Übergangsmetallen, wie beispielsweise Mn und/oder Cu, dotiert sein können (vgl. M. J. Anc, N. L. Pickett et al., ECS Journal of Solid State Science and Technology, 2013, 2(2), R3071-R3082).

Beispiele von Halbleitermaterialien der Gruppe II-VI sind: CdSe, CdS, CdTe, ZnO, ZnSe, ZnS, ZnTe, HgS, HgSe, HgTe, CdZnSe sowie beliebige Kombinationen davon.

Beispiele von Halbleitermaterialien der Gruppe III-V sind: InAs, InP, InN, GaN, InSb, InAsP, InGaAs, GaAs, GaP, GaSb, AlP, AlN, AlAs, AlSb, CdSeTe, ZnCdSe sowie beliebige Kombinationen davon.

Beispiele von Halbleitermaterialien der Gruppe IV-VI sind: PbSe, PbTe, PbS, PbSnTe, $Tl_2SnTe_5$ sowie beliebige Kombinationen davon.

Beispiele von Halbleitermaterialien der Gruppe $I\text{-}III\text{-}VI_2$ sind: $CuGaS_2$, $CuGaSe_2$, $CuInS_2$, $CuInSe_2$, $Cu_2(In\text{-}Ga)S_4$, $AgInS_2$, $AgInSe_2$ sowie beliebige Kombinationen davon.

Die genannten Beispiele der Halbleitermaterialien für die Halbleiter-Nanopartikel dienen alleine der Veranschaulichung und sind hinsichtlich des Umfangs und des Schutzbereichs der vorliegenden Erfindung in keinster Weise als einschränkend zu verstehen. Die genannten Halbleitermaterialien können entweder als Legierung oder als Kern- oder Schalenmaterial in einer Kern-Schale-Konfiguration oder in einer Kern-Mehrschalen-Konfiguration verwendet werden.

Die äußere und innere Form der Halbleiter-Nanopartikel ist nicht weiter beschränkt. Vorzugsweise liegen die Halbleiter-Nanopartikel in Form von Nanopunkten, Nanostäbchen, Nanoplättchen, Nanotetrapods, Nanopunkten in Nanostäbchen, Nanostäbchen in Nanostäbchen und/oder Nanopunkten in Nanoplättchen vor.

Die Länge der Nanostäbchen liegt vorzugsweise zwischen 8 und 500 nm und stärker bevorzugt zwischen 10 und 160 nm. Der Gesamtdurchmesser eines Nanostäbchens liegt vorzugsweise zwischen 1 und 20 nm und stärker bevorzugt zwischen 1 und 10 nm. Ein typisches Nanostäbchen hat ein Seitenverhältnis (Länge zu Durchmesser) von vorzugsweise größer oder gleich 2 und stärker bevorzugt von größer oder gleich 3.

In einer stärker bevorzugten Ausführungsform weisen die Halbleiter-Nanopartikel eine große Stokes-Verschiebung auf und liegen in Form von großen Nanopunkten, Nanopunkten in Nanostäbchen, Nanostäbchen in Nanostäbchen und/oder Nanotetrapods vor.

Die Stokes-Verschiebung beschreibt die Verschiebung der Wellenlänge bzw. der Frequenz von Licht (elektromagnetischer Strahlung) zwischen Absorption und Emission. Die Stokes-Verschiebung ist die Differenz der Energie zwischen ein- und ausgehenden Photonen:

$$\Delta E(Photon) = E(ein) - E(aus)$$

Bei Stoffen, die durch auftreffendes Licht fluoreszieren, ist das wieder ausgestrahlte Licht in der Regel in einen längerwelligen Bereich verschoben, was als Rotverschiebung bezeichnet wird (Stokes'sche Regel).

Halbleiter-Nanopartikel mit einer großen Stokes-Verschiebung im Sinne der vorliegenden Erfindung sind:

(A) Halbleiter-Nanopartikel, deren Maximum der Emission zwischen 580 und 680 nm liegt und die die folgende Bedingung (I) erfüllen:

$$(I) \quad AR_{rot1} = Absorption_{455nm} / max. \ Absorption_{580-680nm} > 3,5 : 1,$$
$$vorzugsweise > 7 : 1,$$

wobei $AR_{rot1}$ das Verhältnis zwischen der Absorption bei 455 nm ($Absorption_{455nm}$) zu der maximalen Absorption im Wellenlängenbereich zwischen 580 und 680 nm (max. $Absorption_{580-680nm}$) bezeichnet.

(B) Halbleiter-Nanopartikel, deren Maximum der Emission zwischen 580 und 680 nm liegt und die die folgende Bedingung (II) erfüllen:

$$(II) \quad AR_{rot2} = Absorption_{405nm} / max. \ Absorption_{580-680nm} > 6 : 1,$$
$$vorzugsweise > 10 : 1,$$

wobei $AR_{rot2}$ das Verhältnis zwischen der Absorption bei 405 nm ($Absorption_{405nm}$) zu der maximalen Absorption im Wellenlängenbereich zwischen 580 und 680 nm (max. $Absorption_{580-680nm}$) bezeichnet.

(C) Halbleiter-Nanopartikel, deren Maximum der Emission zwischen 510 und 580 nm liegt und die die folgende Bedingung (III) erfüllen:

$$(III) \quad AR_{grün1} = Absorption_{455nm} / max. \ Absorption_{510-580nm} > 2,5 : 1,$$
$$vorzugsweise > 6 : 1,$$

wobei $AR_{grün1}$ das Verhältnis zwischen der Absorption bei 455 nm ($Absorption_{455nm}$) zu der maximalen Absorption im Wellenlängenbereich zwischen 510 und 580 nm (max. $Absorption_{510-580nm}$) bezeichnet.

(D) Halbleiter-Nanopartikel, deren Maximum der Emission zwischen 510 und 580 nm liegt und die die folgende Bedingung (IV) erfüllen:

$$(IV) \quad AR_{grün2} = Absorption_{405nm} / max. \ Absorption_{510-580nm} > 3,5 : 1,$$
$$vorzugsweise > 7 : 1,$$

wobei $AR_{grün2}$ das Verhältnis zwischen der Absorption bei 405 nm ($Absorption_{405nm}$) zu der maximalen Absorption im Wellenlängenbereich zwischen 510 und 580 nm (max. $Absorption_{510-580nm}$) bezeichnet.

Die Wellenlänge des emittierten Lichts (Emissionsfarbe) der Halbleiter-Nanopartikel in Antwort auf die Anregungsstrahlung kann in geeigneter Weise durch Einstellen der Form, Größe und/oder der stofflichen Zusammensetzung der Nanopartikel gewählt werden. Diese Flexibilität hinsichtlich der Emissionsfarbe ermöglicht eine große Variation der Farbe des erfindungsgemäßen lichtkonvertierenden Materials. Die Emission von rotem Licht kann beispielsweise durch CdSe-Nanopunkte, CdSe-Nanostäbchen, CdSe-Nanopunkte in CdS-Nanostäbchen, ZnSe-Nanopunkte in CdS-Nanostäbchen, CdSe/ZnS-Nanostäbchen, InP-Nanopunkte, InP-Nanostäbchen, CdSe/CdS-Nanostäbchen, ZnSe-Nanopunkte in CdS-Nanostäbchen und ZnSe/CdS-Nanostäbchen erzielt werden. Die Emission von grünem Licht kann beispielsweise durch CdSe-Nanopunkte, CdSe-Nanostäbchen, CdSe/CdS-Nanostäbchen und CdSe/ZnS-Nanostäbchen erzielt werden. Die Emission von blauem Licht kann beispielsweise durch Kern-Schale-Nanopunkte oder Kern-Schale-Nanostäbchen auf der Basis von ZnSe, ZnS, ZnSe/ZnS und/oder CdS erzielt werden. Diese beispielhafte Zuordnung zwischen bestimmten Halbleiter-Nanopartikeln und bestimmten Emissionsfarben ist nicht abschließend und soll lediglich der Veranschaulichung dienen. Dem Fachmann ist bewusst, dass durch Einstellen der Größe der Halbleiter-Nanopartikel verschiedene Emissionsfarben innerhalb bestimmter materialabhängiger Grenzen erzielt werden können.

Weitere bevorzugte Halbleiter-Nanopartikel sind Nanostäbchen mit einer Kern-Schale-Konfiguration mit Materialien, ausgewählt aus CdSe/CdS, CdSeS/CdS, ZnSe/CdS, ZnCdSe/CdS, CdSe/CdZnS, CdTe/CdS, InP/ZnSe, InP/CdS, InP/ZnS und CuInS$_2$/ZnS; sowie Nanostäbchen mit einer Kern-Mehrschalen-Konfiguration, ausgewählt aus CdSe/CdS/ZnS, CdSe/CdZnS/ZnS, ZnSe/CdS/ZnS, InP/ZnSe/ZnS, InP/CdS/ZnS und InP/CdZnS/ZnS.

In einer bevorzugten Ausführungsform werden die Halbleiter-Nanopartikel auf die Oberfläche eines unaktivierten kristallinen Materials, wie oben beschrieben, aufgebracht, so dass die Halbleiter-Nanopartikel in einem Verhältnis von 0,1 bis 20 Gew.-%, vorzugsweise von 0,5 bis 2 Gew.-%, bezogen auf das unaktivierte kristalline Material, vorliegen.

In der vorliegenden Erfindung ist die Oberfläche der Halbleiter-Nanopartikel mit einem oder mehreren Liganden beschichtet. Die Liganden unterliegen keiner besonderen Einschränkung, sofern sie sich für die Oberflächenbeschichtung von Halbleiter-Nanopartikeln eignen. Geeignete Liganden sind beispielsweise Phosphine und Phosphinoxide, wie Trioctylphosphinoxid (TOPO), Trioctylphosphin (TOP) oder Tributylphosphin (TBP); Phosphonsäuren, wie Dodecylphosphonsäure (DDPA), Tridecylphosphonsäure (TBPA), Octadecylphosphonsäure (ODPA) oder Hexylphosphonsäure (HPA); Amine, wie Dodecylamin (DDA), Tetradecylamin (TDA), Hexadecylamin (HDA) oder Octadecylamin (ODA); Thiole, wie Hexadecanthiol oder Hexanthiol; Mercaptocarbonsäuren, wie Mercaptopropionsäure oder Mercaptoundecansäure; und andere Säuren, wie Myristinsäure, Palmitinsäure oder Ölsäure. Es ist nicht beabsichtigt, dass die zuvor genannten Beispiele als einschränkend zu verstehen sind.

Es ist ferner bevorzugt, dass die Oberfläche des lichtkonvertierenden Materials der vorliegenden Erfindung mit einem oder mehreren Beschichtungsmaterialien beschichtet ist. Die Beschichtungsmaterialien unterliegen keiner besonderen Einschränkung, sofern sie sich für die Beschichtung der Oberfläche des lichtkonvertierenden Materials eignen. Geeignet sind beispielsweise Materialien, die auch für die Beschichtung von Leuchtstoffen verwendet werden, wie beispielsweise anorganische oder organische Beschichtungsmaterialien. Die anorganischen Beschichtungsmaterialien können dielektrische Isolatoren, Metalloxide (einschließlich transparenter leitfähiger Oxide), Metallnitride oder Siliciumdioxid-basierte Materialien (z.B. Gläser) sein. Wenn ein Metalloxid verwendet wird, kann das Metalloxid ein einzelnes Metalloxid (d.h. Oxidionen, die mit einem einzelnen Metallion-Typ kombiniert sind, wie z.B. Al$_2$O$_3$) oder ein gemischtes Metalloxid (d.h. Oxidionen, die mit zwei oder mehr Metallion-Typen kombiniert sind, wie z.B. SrTiO$_3$, oder ein dotiertes Metalloxid, wie ein dotiertes transparentes leitfähiges Oxid (TCO), wie z.B. Al-dotiertes ZnO, Ga-dotiertes ZnO, etc.) sein. Das Metallion oder die Metallionen des (gemischten) Metalloxids können aus jeder geeigneten Gruppe des Periodensystems ausgewählt werden, wie beispielsweise Gruppe 2, 13, 14 oder 15, oder sie können ein d-Metall oder ein Lanthanidmetall sein.

Besondere Metalloxide schließen ein, sind jedoch nicht beschränkt auf: Al$_2$O$_3$, ZnO, HfO$_2$, SiO$_2$, ZrO$_2$ und TiO$_2$, einschließlich Kombinationen, Legierungen und/oder dotierte Spezies davon; und/oder TCOs, wie z.B. Al-dotiertes ZnO, Ga-dotiertes ZnO und In$_2$O$_3$. Die anorganischen Beschichtungen schließen Siliciumdioxid in jeder geeigneten Form ein. In einigen Ausführungsformen ist ein oder mehrere der anorganischen Beschichtungsmaterialien ein Metalloxid, das aus der Gruppe bestehend aus Al$_2$O$_3$, ZnO, TiO$_2$, In$_2$O$_3$ oder Kombinationen und/oder dotierten Spezies davon ausgewählt ist. In besonderen Ausführungsformen ist das Metalloxid ein TCO, z.B. Al-dotiertes ZnO oder Ga-dotiertes ZnO.

Besondere Metallnitride schließen ein, sind jedoch nicht beschränkt auf: AlN, BN, Si$_3$N$_4$, einschließlich Kombinationen, Legierungen und/oder dotierte Spezies davon.

Es ist auch möglich, alternativ und/oder zusätzlich zu der oben genannten anorganischen Beschichtung eine organische Beschichtung aufzubringen. Die organische Beschichtung kann sich ebenfalls vorteilhaft auf die Stabilität und Haltbarkeit der lichtkonvertierenden Materialien sowie die Dispergierbarkeit auswirken. Geeignete organische Materialien sind (Poly)silazane, wie vorzugsweise modifizierte organische Polysilazane (MOPS) oder Perhydropolysilazane (PHPS), sowie Mischungen davon, organische Silane und auch andere organische Materialien bis hin zu Polymeren.

Im Stand der Technik sind zahlreiche Verfahren zum Aufbringen von Beschichtungsmaterialien auf lichtkonvertierende Materialien oder Leuchtstoffe bekannt. So beschreibt beispielsweise die WO 2014/140936, deren Inhalt hiermit durch Bezugnahme in die vorliegende Anmeldung aufgenommen wird, Verfahren, wie beispielsweise die chemische Gasphasenabscheidung (CVD), physikalische Gasphasenabscheidung (PVD) (einschließlich Magnetron-Sputtern), Vitex-Technologie, Atomschichtabscheidung (ALD) und Molekularschichtabscheidung (MLD). Ferner kann die Beschichtung durch ein Wirbelschichtverfahren durchgeführt werden. Weitere Beschichtungsverfahren werden in der JP 04-304290, WO 91/10715, WO 99/27033, US 2007/0298250, WO 2009/065480 und WO 2010/075908 beschrieben, deren Inhalte hiermit durch Bezugnahme eingeschlossen werden.

Um eine mehrschichtige Beschichtung aufzubauen, können nacheinander unterschiedliche Beschichtungsmaterialien aufgebracht werden. Zahlreiche Beschichtungsmaterialien, wie beispielsweise Metalloxide, wie z.B. Al$_2$O$_3$, SiO$_2$, ZnO, TiO$_2$ und ZrO$_2$; Metalle, wie z.B. Pt und Pd; und Polymere, wie z.B. Poly(amide) und Poly(imide), können für die Beschichtung des lichtkonvertierenden Materials gemäß der vorliegenden Erfindung verwendet werden. $Al_2O_3$ ist eines der am besten untersuchten Beschichtungsmaterialien, das mit Hilfe des Atomschichtabscheidungs-(ALD)-Verfahrens aufgebracht wird. $Al_2O_3$ kann durch wechselseitiges Anwenden von Trimethylaluminium und Wasserdampf als entsprechende Metall- und Sauerstoffquellen und Spülen der ALD-Kammer zwischen jeder dieser Anwendungen mit einem inerten Trägergas, wie z.B. $N_2$ oder Ar, auf einem Substrat aufgebracht werden.

Die vorliegende Erfindung betrifft ferner eine lichtkonvertierende Mischung, die eines oder mehrere der erfindungsgemäßen lichtkonvertierenden Materialien umfasst. Es ist auch möglich, dass die lichtkonvertierende Mischung neben den erfindungsgemäßen lichtkonvertierenden Materialien einen oder mehrere Konversionsleuchtstoffe enthält. Es ist bevorzugt, dass die lichtkonvertierenden Materialien und die Konversionsleuchtstoffe Licht unterschiedlicher Wellenlängen emittieren, die komplementär zueinander sind. Wenn es sich bei dem erfindungsgemäßen lichtkonvertierenden Material um ein rot emittierendes Material handelt, wird dieses bevorzugt in Kombination mit einem cyan emittierenden Konversionsleuchtstoff oder in Kombination mit blau und grün bzw. gelb emittierenden Konversionsleuchtstoffen eingesetzt. Wenn es sich bei dem erfindungsgemäßen lichtkonvertierenden Material um ein grün emittierendes Material handelt, wird dieses bevorzugt in Kombination mit einem magenta emittierenden Konversionsleuchtstoff oder in Kombination mit rot und blau emittierenden Konversionsleuchtstoffen eingesetzt. Es kann also bevorzugt sein, dass das erfindungsgemäße lichtkonvertierende Material in Kombination mit einem oder mehreren weiteren Konversionsleuchtstoffen in der erfindungsgemäßen lichtkonvertierenden Mischung eingesetzt wird, so dass vorzugsweise weißes Licht emittiert wird.

Es ist bevorzugt, dass die lichtkonvertierende Mischung das erfindungsgemäße lichtkonvertierende Material in einem Verhältnis von 1 bis 90 Gew.-%, bezogen auf das Gesamtgewicht der Mischung, umfasst.

Im Kontext dieser Anmeldung wird als violettes Licht solches Licht bezeichnet, dessen Emissionsmaximum unter 420 nm liegt, als blaues Licht solches Licht bezeichnet, dessen Emissionsmaximum zwischen 420 und 469 nm liegt, als cyan-farbenes Licht solches, dessen Emissionsmaximum zwischen 470 und 505 nm liegt, als grünes Licht solches, dessen Emissionsmaximum zwischen 506 und 545 nm liegt, als gelbes Licht solches, dessen Emissionsmaximum zwischen 546 und 569 nm liegt, als orange Licht solches, dessen Emissionsmaximum zwischen 570 und 600 nm liegt und als rotes Licht solches, dessen Emissionsmaximum zwischen 601 und 670 nm liegt. Das erfindungsgemäße lichtkonvertierende Material ist vorzugsweise ein rot- oder grün-emittierender Konversionsstoff. Magenta entsteht durch additive Mischung der maximalen Intensitäten für Rot und Blau und entspricht im RGB-Farbraum dem Dezimalwert (255, 0, 255) bzw. dem Hexadezimalwert (FF00FF).

Die Konversionsleuchtstoffe, die zusammen mit dem erfindungsgemäßen lichtkonvertierenden Material eingesetzt werden können und die erfindungsgemäße lichtkonvertierende Mischung bilden, unterliegen keiner besonderen Einschränkung. Es kann daher generell jeder mögliche Konversionsleuchtstoff eingesetzt werden. Dabei eignen sich beispielsweise: $Ba_2SiO_4{:}Eu^{2+}$, $BaSi_2O_5{:}Pb^{2+}$, $Ba_xSr_{1-x}F_2{:}EU^{2+}$, $BaSrMgSi_2O_7{:}Eu^{2+}$, $BaTiP_2O_7$, $(Ba,Ti)_2P_2O_7{:}Ti$, $Ba_3WO_6{:}U$, $BaY_2F_8{:}Er^{3+},Yb^+$, $Be_2SiO_4{:}Mn^{2+}$, $Bi_4Ge_3O_{12}$, $CaAl_2O_4{:}Ce^{3+}$, $CaLa_4O_7{:}Ce^{3+}$, $CaAl_2O_4{:}Eu^{2+}$, $CaAl_2O_4{:}Mn^{2+}$, $CaAl_4O_7{:}Pb^{2+}$, $Mn^{2+}$, $CaAl_2O_4{:}Tb^{3+}$, $Ca_3Al_2Si_3O_{12}{:}Ce^{3+}$, $Ca_3Al_2Si_3O_{12}{:}Eu^{2+}$, $Ca_2B_5O_9Br{:}Eu^{2+}$, $Ca_2B_5O_9Cl{:}Eu^{2+}$, $Ca_2B_5O_9Cl{:}Pb^{2+}$, $CaB_2O_4{:}Mn^{2+}$, $Ca_2B_2O_5{:}Mn^{2+}$, $CaB_2O_4{:}Pb^{2+}$ $CaB_2P_2O_9{:}Eu^{2+}$, $CasB_2SiO_{10}{:}Eu^{3+}$, $Ca_{0.5}Ba_{0.5}Al_{12}O_{19}{:}Ce^{3+},Mn^{2+}$, $Ca_2Ba_3(PO_4)_3Cl{:}Eu^{2+}$, $CaBr_2{:}Eu^{2+}$ in $SiO_2$, $CaCl_2{:}Eu^{2+}$ in $SiO_2$, $CaCl_2{:}Eu^{2+},Mn^{2+}$ in $SiO_2$, $CaF_2{:}Ce^{3+}$, $CaF_2{:}Ce^{3+},Mn^{2+}$, $CaF_2{:}Ce^{3+},Tb^{3+}$, $CaF_2{:}Eu^{2+}$, $CaF_2{:}Mn^{2+}$, $CaF_2{:}U$, $CaGa_2O_4{:}Mn^{2+}$, $CaGa_4O_7{:}Mn^{2+}$, $CaGa_2S_4{:}Ce^{3+}$, $CaGa_2S_4{:}Eu^{2+}$, $CaGa_2S_4{:}Mn^{2+}$, $CaGa_2S_4{:}Pb^{2+}$, $CaGeO_3{:}Mn^{2+}$, $CaI_2{:}Eu^{2+}$ in $SiO_2$, $CaI_2{:}Eu^{2+},Mn^{2+}$ in $SiO_2$, $CaLaBO_4{:}Eu^{3+}$, $CaLaB_3O_7{:}Ce^{3+},Mn^{2+}$, $Ca_2La_2BO_{6.5}{:}Pb^{2+}$, $Ca_2MgSi_2O_7$, $Ca_2MgSi_2O_7{:}Ce^{3+}$, $CaMgSi_2O_6{:}Eu^{2+}$, $Ca_3MgSi_2O_8{:}Eu^{2+}$, $Ca_2MgSi_2O_7{:}Eu^{2+}$, $CaMgSi_2O_6{:}Eu^{2+},Mn^{2+}$, $Ca_2MgSi_2O_7{:}Eu^{2+},Mn^{2+}$, $CaMoO_4$, $CaMoO_4{:}Eu^{3+}$, $CaO{:}Bi^{3+}$, $CaO{:}Cd^{2+}$, $CaO{:}Cu^+$, $CaO{:}Eu^{3+}$, $CaO{:}Eu^{3+}$, $Na^+$, $CaO{:}Mn^{2+}$, $CaO{:}Pb^{2+}$, $CaO{:}Sb^{3+}$, $CaO{:}Sm^{3+}$, $CaO{:}Tb^{3+}$, $CaO{:}Tl$, $CaO{:}Zn^{2+}$, $Ca_2P_2O_7{:}Ce^{3+}$, $\alpha\text{-}Ca_3(PO_4)_2{:}Ce^{3+}$, $\beta\text{-}Ca_3(PO_4)_2{:}Ce^{3+}$, $Ca_5(PO_4)_3Cl{:}Eu^{2+}$, $Ca_5(PO_4)_3Cl{:}Mn^{2+}$, $Ca_5(PO_4)_3Cl{:}Sb^{3+}$, $Ca_5(PO_4)_3Cl{:}Sn^{2+}$, $\beta\text{-}Ca_3(PO_4)_2{:}Eu^{2+}Mn^{2+}$, $Ca_5(PO_4)_3F{:}Mn^{2+}$, $Ca_5(PO_4)_3F{:}Sb^{3+}$, $Ca_5(PO_4)_3F{:}Sn^{2+}$, $\alpha\text{-}Ca_3(PO_4)_2{:}Eu^{2+}$, $\beta\text{-}Ca_3(PO_4)_2{:}Eu^{2+}$, $Ca_2P_2O_7{:}Eu^{2+}$, $Ca_2P_2O_7{:}Eu^{2+},Mn^{2+}$, $CaP_2O_6{:}Mn^{2+}$, $\alpha\text{-}Ca_3(PO_4)_2{:}Pb^{2+}$, $\alpha\text{-}Ca_3(PO_4)_2{:}Sn^{2+}$, $\beta\text{-}Ca_3(PO_4)_2{:}Sn^{2+}$, $\beta\text{-}Ca_2P_2O_7{:}Sn,Mn$, $\alpha\text{-}Ca_3(PO_4)_2{:}Tr$, $CaS{:}Bi^{3+}$, $CaS{:}Bi^{3+},Na$, $CaS{:}Ce^{3+}$, $CaS{:}Eu^{2+}$, $CaS{:}Cu^+,Na^+$, $CaS{:}La^{3+}$, $CaS{:}Mn^{2+}$, $CaSO_4{:}Bi$, $CaSO_4{:}Ce^{3+}$, $CaSO_4{:}Ce^{3+},Mn^{2+}$, $CaSO_4{:}Eu^{2+}$, $CaSO_4{:}Eu^{2+},Mn^{2+}$, $CaSO_4{:}Pb^{2+}$, $CaS{:}Pb^{2+}$, $CaS{:}Pb^{2+},Cl$, $CaS{:}Pb^{2+},Mn^{2+}$, $CaS{:}Pr^{3+},Pb^{2+},Cl$, $CaS{:}Sb^{3+}$, $CaS{:}Sb^{3+},Na$, $CaS{:}Sm^{3+}$, $CaS{:}Sn^{2+}$, $CaS{:}Sn^{2+},F$, $CaS{:}Tb^{3+}$, $CaS{:}Tb^{3+},Cl$, $CaS{:}Y^{3+}$, $CaS{:}Yb^{2+}$, $CaS{:}Yb^{2+},Cl$, $CaSiO_3{:}Ce^{3+}$, $Ca_3SiO_4Cl_2{:}Eu^{2+}$, $Ca_3SiO_4Cl_2{:}Pb^{2+}$, $CaSiO_3{:}Eu^{2+}$, $CaSiO_3{:}Mn^{2+},Pb$, $CaSiO_3{:}Pb^{2+}$, $CaSiO_3{:}Pb^{2+},Mn^{2+}$, $CaSiO_3{:}Ti^{4+}$, $CaSr_2(PO_4)_2{:}Bi^{3+}$, $\beta\text{-}(Ca,Sr)_3(PO_4)_2{:}Sn^{2+}Mn^{2+}$, $CaTi_{0.9}Al_{0.1}O_3{:}Bi^{3+}$, $CaTiO_3{:}Eu^{3+}$, $CaTiO_3{:}Pr^{3+}$ $Ca_5(VO_4)_3Cl$, $CaWO_4$, $CaWO_4{:}Pb^{2+}$, $CaWO_4{:}W$, $Ca_3WO_6{:}U$, $CaYAlO_4{:}Eu^{3+}$, $CaYBO_4{:}Bi^{3+}$, $CaYBO_4{:}Eu^{3+}$, $CaYB_{0.8}O_{3.7}{:}Eu^{3+}$, $CaY_2ZrO_6{:}Eu^{3+}$, $(Ca,Zn,Mg)_3(PO_4)_2{:}Sn$, $CeF_3$, $(Ce,Mg)BaAl_{11}O_{18}{:}Ce$, $(Ce,Mg)SrAl_{10}O_{18}{:}Ce$, $CeMgAl_{11}O_{19}{:}Ce{:}Tb$, $Cd_2B_6O_{11}{:}Mn^{2+}$, $CdS{:}Ag^+,Cr$, $CdS{:}In$, $CdS{:}In$, $CdS{:}In,Te$, $CdS{:}Te$, $CdWO_4$, $CsF$, $CsI$, $CsI{:}Na^+$, $CsI{:}Tl$, $(ErCl_3)_{0.25}(BaCl_2)_{0.75}$, $GaN{:}Zn$, $Gd_3Ga_5O_{12}{:}Cr^{3+}$, $Gd_3Ga_5O_{12}{:}Cr,Ce$, $GdNbO_4{:}Bi^{3+}$, $Gd_2O_2S{:}EU^{3+}$, $Gd_2O_2SPr^{3+}$, $Gd_2O_2S{:}Pr,Ce,F$, $Gd_2O_2S{:}Tb^{3+}$, $Gd_2SiO_5{:}Ce^{3+}$, $KAl_{11}O_{17}{:}Tl^+$, $KGa_{11}O_{17}{:}Mn^{2+}$, $K_2La_2Ti_3O_{10}{:}Eu$, $KMgF_3{:}Eu^{2+}$, $KMgF_3{:}Mn^{2+}$, $K_2SiF_6{:}Mn^{4+}$, $LaAl_3B_4O_{12}{:}Eu^{3+}$, $LaAlB_2O6{:}Eu^{3+}$, $LaAlO_3{:}Eu^{3+}$, $LaAlO_3{:}Sm^{3+}$, $LaAsO_4{:}Eu^{3+}$, $LaBr_3{:}Ce^{3+}$, $LaBO_3{:}Eu^{3+}$, $(La,Ce,Tb)PO_4{:}Ce{:}Tb$, $LaCl_3{:}Ce^{3+}$, $La_2O_3{:}Bi^{3+}$, $LaOBr{:}Tb^{3+}$, $LaOBr{:}Tm^{3+}$, $LaOCl{:}Bi^{3+}$, $LaOCl{:}Eu^{3+}$, $LaOF{:}Eu^{3+}$,

$La_2O_3$:$Eu^{3+}$, $La_2O_3$:$Pr^{3+}$, $La_2O_2S$:$Tb^{3+}$, $LaPO_4$:$Ce^{3+}$, $LaPO_4$:$Eu^{3+}$, $LaSiO_3Cl$:$Ce^{3+}$, $LaSiO_3Cl$:$Ce^{3+}$,$Tb^{3+}$, $LaVO_4$:$Eu^{3+}$, $La_2W_3O_{12}$:$Eu^{3+}$, $LiAlF_4$:$Mn^{2+}$, $LiAl_5O_8$:$Fe^{3+}$, $LiAlO_2$:$Fe^{3+}$, $LiAlO_2$:$Mn^{2+}$, $LiAl_5O_8$:$Mn^{2+}$, $Li_2CaP_2O_7$:$Ce^{3+}$,$Mn^{2+}$, $LiCeBa_4Si_4O_{14}$:$Mn^{2+}$, $LiCeSrBa_3Si_4O_{14}$:$Mn^{2+}$, $LiInO_2$:$Eu^{3+}$, $LiInO_2$:$Sm^{3+}$, $LiLaO_2$:$Eu^{3+}$, $LuAlO_3$:$Ce^{3+}$, $(Lu,Gd)_2SiO_5$:$Ce^{3+}$, $Lu_2SiO_5$:$Ce^{3+}$, $Lu_2Si_2O_7$:$Ce^{3+}$, $LuTaO_4$:$Nb^{5+}$, $Lu_{1-x}Y_xAlO_3$:$Ce^{3+}$, $MgAl_2O_4$:$Mn^{2+}$, $MgSrAl_{10}O_{17}$:$Ce$, $MgB_2O_4$:$Mn^{2+}$, $MgBa_2(PO_4)_2$:$Sn^{2+}$, $MgBa_2(PO_4)_2$:$U$, $MgBaP_2O_7$:$Eu^{2+}$, $MgBaP_2O_7$:$Eu^{2+}$,$Mn^{2+}$, $MgBa_3Si_2O_8$:$Eu^{2+}$, $MgBa(SO_4)_2$:$Eu^{2+}$, $Mg_3Ca_3(PO_4)_4$:$Eu^{2+}$, $MgCaP_2O_7$:$Mn^{2+}$, $Mg_2Ca(SO_4)_3$:$Eu^{2+}$, $Mg_2Ca(SO_4)_3$:$Eu^{2+}$,$Mn2$, $MgCeAl_{11}O_{19}$:$Tb^{3+}$, $Mg_4(F)GeO_6$:$Mn^{2+}$, $Mg_4(F)(Ge,Sn)O_6$:$Mn^{2+}$, $MgF_2$:$Mn^{2+}$, $MgGa_2O_4$:$Mn^{2+}$, $Mg_8Ge_2O_{11}F_2$:$Mn^{4+}$, $MgS$:$Eu^{2+}$, $MgSiO_3$:$Mn^{2+}$, $Mg_2SiO_4$:$Mn^{2+}$, $Mg_3SiO_3F_4$:$Ti^{4+}$, $MgSO4$:$Eu^{2+}$, $MgSO_4$:$Pb^{2+}$, $(Mg,Sr)Ba_2Si_2O_7$:$Eu^{2+}$, $MgSrP_2O_7$:$Eu^{2+}$, $MgSr_5(PO_4)_4$:$Sn^{2+}$, $MgSr_3Si_2O_8$:$Eu^{2+}$,$Mn^{2+}$, $Mg_2Sr(SO_4)_3$:$EU^{2+}$, $Mg_2TiO_4$:$Mn^{4+}$, $MgWO_4$, $MgYBO_4$:$Eu^{3+}$, $Na_3Ce(PO_4)_2$:$Tb^{3+}$, $NaI$:$Tl$, $Na_{1,23}K_{0,42}Eu_{0,12}TiSi_4O_{11}$:$Eu^{3+}$, $Na_{1,23}K_{0,42}Eu_{0,12}TiSi_5O_{13}.XH_2O$:$Eu^{3+}$, $Na_{1,29}K_{0,46}Er_{0,08}TiSi_4O_{11}$:$Eu^{3+}$, $Na_2Mg_3Al_2Si_2O_{10}$:$Tb$, $Na(Mg_{2-x}Mn_x)LiSi_4O_{10}F_2$:$Mn$, $NaYF_4$:$Er^{3+}$, $Yb^{3+}$, $NaYO_2$:$Eu^{3+}$, $P46(70\%) + P47 (30\%)$, $SrAl_{12}O_{19}$:$Ce^{3+}$, $Mn^{2+}$, $SrAl_2O_4$:$Eu^{2+}$, $SrAl_4O_7$:$Eu^{3+}$, $SrAl_{12}O_{19}$:$Eu^{2+}$, $SrAl_2S_4$:$Eu^{2+}$, $Sr_2B_5O_9Cl$:$Eu^{2+}$, $SrB_4O_7$:$Eu^{2+}$($F,Cl,Br$), $SrB_4O_7$:$Pb^{2+}$, $SrB_4O_7$:$Pb^{2+}$, $Mn^{2+}$, $SrB_8O_{13}$:$Sm^{2+}$, $Sr_xBa_yCl_zAl_2O_{4-z/2}$: $Mn^{2+}$, $Ce^{3+}$, $SrBaSiO_4$:$Eu^{2+}$, $Sr(Cl,Br,I)_2$:$Eu^{2+}$ in $SiO_2$, $SrCl_2$:$Eu^{2+}$ in $SiO_2$, $Sr_5Cl(PO_4)_3$:$Eu$, $SrF_xB_4O_{6.5}$:$Eu^{2+}$, $Sr_wF_xB_y$-$O_z$:$Eu^{2+}$,$Sm^{2+}$, $SrF_2$:$Eu^{2+}$, $SrGa_{12}O_{19}$:$Mn^{2+}$, $SrGa_2S_4$:$Ce^{3+}$, $SrGa_2S_4$:$Eu^{2+}$, $SrGa_2S_4$:$Pb^{2+}$, $SrIn_2O_4$:$Pr^{3+}$, $Al^{3+}$, $(Sr,Mg)_3(PO_4)_2$:$Sn$, $SrMgSi_2O_6$:$Eu^{2+}$, $Sr_2MgSi_2O_7$:$Eu^{2+}$, $Sr_3MgSi_2O_8$:$Eu^{2+}$, $SrMoO_4$:$U$, $SrO·3B_2O_3$:$Eu^{2+}$,$Cl$, β-$SrO·3B_2O_3$:$Pb^{2+}$, β-$SrO·3B_2O_3$:$Pb^{2+}$,$Mn^{2+}$, α-$SrO·3B_2O_3$:$Sm^{2+}$ $Sr_6P_5BO_{20}$:$Eu$, $Sr_5(PO_4)_3Cl$:$Eu^{2+}$, $Sr_5(PO_4)_3Cl$:$Eu^{2+}$,$Pr^{3+}$, $Sr_5(PO_4)_3Cl$:$Mn^{2+}$, $Sr_5(PO_4)_3Cl$:$Sb^{3+}$, $Sr_2P_2O_7$:$Eu^{2+}$, β-$Sr_3(PO_4)_2$:$Eu^{2+}$, $Sr_5(PO_4)_3F$:$Mn^{2+}$, $Sr_5(PO_4)_3F$:$Sb^{3+}$, $Sr_5(PO_4)_3F$:$Sb^{3+}$,$Mn^{2+}$, $Sr_5(PO_4)_3F$:$Sn^{2+}$, $Sr_2P_2O7$:$Sn^{2+}$, β-$Sr_3(PO_4)_2$:$Sn^{2+}$, β-$Sr_3(PO_4)_2$:$Sn^{2+}$,$Mn^{2+}(Al)$, $SrS$:$Ce^{3+}$, $SrS$:$Eu^{2+}$, $SrS$:$Mn^{2+}$, $SrS$:$Cu^+$,$Na$, $SrSO_4$:$Bi$, $SrSO_4$:$Ce^{3+}$, $SrSO_4$:$Eu^{2+}$, $SrSO_4$:$Eu^{2+}$,$Mn^{2+}$, $Sr_5Si_4O_{10}Cl_6$:$Eu^{2+}$, $Sr_2SiO_4$:$Eu^{2+}$, $SrTiO_3$:$Pr^{3+}$, $SrTiO_3$:$Pr^{3+}$,$Al^{3+}$, $Sr_3WO6$:$U$, $SrY_2O_3$:$Eu^{3+}$, $ThO_2$:$Eu^{3+}$, $ThO_2$:$Pr^{3+}$, $ThO_2$:$Tb^{3+}$, $YAl_3B_4O_{12}$:$Bi^{3+}$, $YAl_3B_4O_{12}$:$Ce^{3+}$, $YAl_3B_4O_{12}$:$Ce^{3+}$,$Mn$, $YAl_3B_4O_{12}$:$Ce^{3+}$,$Tb^{3+}$, $YAl_3B_4O_{12}$:$Eu^{3+}$, $YAl_3B_4O_{12}$:$Eu^{3+}$,$Cr^{3+}$, $YAl_3B_4O_{12}$:$Th^{4+}$,$Ce^{3+}$,$Mn^{2+}$, $YAlO_3$:$Ce^{3+}$, $Y_3Al_5O_{12}$:$Ce^{3+}$, $Y_3Al_5O_{12}$:$Cr^{3+}$, $YAlO_3$:$Eu^{3+}$, $Y_3Al_5O_{12}$:$Eu^{3r}$, $Y_4Al_2O_9$:$Eu^{3+}$, $Y_3Al_5O_{12}$:$Mn^{4+}$, $YAlO_3$:$Sm^{3+}$, $YAlO_3$:$Tb^{3+}$, $Y_3Al_5O_{12}$:$Tb^{3+}$, $YAsO_4$:$Eu^{3+}$, $YBO_3$:$Ce^{3+}$, $YBO_3$:$Eu^{3+}$, $YF_3$:$Er^{3+}$,$Yb^{3+}$, $YF_3$:$Mn^{2+}$, $YF_3$:$Mn^{2+}$,$Th^{4+}$, $YF_3$:$Tm^{3+}$,$Yb^{3+}$, $(Y,Gd)BO_3$:$Eu$, $(Y,Gd)BO_3$:$Tb$, $(Y,Gd)_2O_3$:$Eu^{3+}$, $Y_{1,34}Gd_{0,60}O_3(Eu,Pr)$, $Y_2O_3$:$Bi^{3+}$, $YOBr$:$Eu^{3+}$, $Y_2O_3$:$Ce$, $Y_2O_3$:$Er^{3+}$, $Y_2O_3$:$Eu^{3+}(YOE)$, $Y_2O_3$:$Ce^{3+}$,$Tb^{3+}$, $YOCl$:$Ce^{3+}$, $YOCl$:$Eu^{3+}$, $YOF$:$Eu^{3+}$, $YOF$:$Tb^{3+}$, $Y_2O_3$:$Ho^{3+}$, $Y_2O_2S$:$Eu^{3+}$, $Y_2O_2S$:$Pr^{3+}$, $Y_2O_2S$:$Tb^{3+}$, $Y_2O_3$:$Tb^{3+}$, $YPO_4$:$Ce^{3+}$, $YPO_4$:$Ce^{3+}$,$Tb^{3+}$, $YPO_4$:$Eu^{3+}$, $YPO_4$:$Mn^{2+}$,$Th^{4+}$, $YPO_4$:$V^{5+}$, $Y(P,V)O_4$:$Eu$, $Y_2SiO_5$:$Ce^{3+}$, $YTaO_4$, $YTaO_4$:$Nb^{5+}$, $YVO_4$:$Dy^{3+}$, $YVO_4$:$Eu^{3+}$, $ZnAl_2O_4$:$Mn^{2+}$, $ZnB_2O_4$:$Mn^{2+}$, $ZnBa_2S_3$:$Mn^{2+}$, $(Zn,Be)_2SiO_4$:$Mn^{2+}$, $Zn_{0,4}Cd_{0,6}S$:$Ag$, $Zn_{0,6}Cd_{0,4}S$:$Ag$, $(Zn,Cd)S$:$Ag,Cl$, $(Zn,Cd)S$:$Cu$, $ZnF_2$:$Mn^{2+}$, $ZnGa_2O_4$, $ZnGa_2O_4$:$Mn^{2+}$, $ZnGa_2S_4$:$Mn^{2+}$, $Zn_2GeO_4$:$Mn^{2+}$, $(Zn,Mg)F_2$:$Mn^{2+}$, $ZnMg_2(PO_4)_2$:$Mn^{2+}$, $(Zn,Mg)_3(PO_4)_2$:$Mn^{2+}$, $ZnO$:$Al^{3+}$,$Ga^{3+}$, $ZnO$:$Bi^{3+}$, $ZnO$:$Ga^{3+}$, $ZnO$:$Ga$, $ZnO-CdO$:$Ga$, $ZnO$:$S$, $ZnO$:$Se$, $ZnO$:$Zn$, $ZnS$:$Ag^+$,$Cl^-$, $ZnS$:$Ag,Cu,Cl$, $ZnS$:$Ag,Ni$, $ZnS$:$Au,In$, $ZnS-CdS$ (25-75), $ZnS-CdS$ (50-50), $ZnS-CdS$ (75-25), $ZnS-CdS$:$Ag,Br,Ni$, $ZnS-CdS$:$Ag^+$,$Cl$, $ZnS-CdS$:$Cu,Br$, $ZnS-CdS$:$Cu,I$, $ZnS$:$Cl^-$, $ZnS$:$Eu^{2+}$, $ZnS$:$Cu$, $ZnS$:$Cu^+$,$Al^{3+}$, $ZnS$:$Cu^+$,$Cl^-$, $ZnS$:$Cu,Sn$, $ZnS$:$Eu^{2+}$, $ZnS$:$Mn^{2+}$, $ZnS$:$Mn,Cu$, $ZnS$:$Mn^{2+}$,$Te^{2+}$, $ZnS$:$P$, $ZnS$:$P^{3-}$,$Cl^-$, $ZnS$:$Pb^{2+}$, $ZnS$:$Pb^{2+}$,$Cl^-$, $ZnS$:$Pb,Cu$, $Zn_3(PO_4)_2$:$Mn^{2+}$, $Zn_2SiO_4$:$Mn^{2+}$, $Zn_2SiO_4$:$Mn^{2+}$,$As^{5+}$, $Zn_2SiO_4$:$Mn,Sb_2O_2$, $Zn_2SiO_4$:$Mn^{2+}$,$P$, $Zn_2SiO_4$:$Ti^{4+}$, $ZnS$:$Sn^{2+}$, $ZnS$:$Sn,Ag$, $ZnS$:$Sn^{2+}$,$Li^+$, $ZnS$:$Te,Mn$, $ZnS-ZnTe$:$Mn^{2+}$, $ZnSe$:$Cu^+$,$Cl$ und $ZnWO_4$.

Das lichtkonvertierende Material oder die lichtkonvertierende Mischung gemäß der vorliegenden Erfindung kann zur teilweisen oder vollständigen Konversion von ultraviolettem und/oder blauem Licht in Licht mit einer größeren Wellenlänge, wie beispielsweise grünes oder rotes Licht, verwendet werden. Ein weiterer Gegenstand der vorliegenden Erfindung ist somit die Verwendung des lichtkonvertierenden Materials bzw. der lichtkonvertierenden Mischung in einer Lichtquelle. Besonders bevorzugt ist die Lichtquelle eine LED, insbesondere eine phosphorkonvertierte LED, kurz pc-LED. Hierbei ist es besonders bevorzugt, dass das lichtkonvertierende Material mit mindestens einem weiteren lichtkonvertierenden Material und/oder einem oder mehreren Konversionsleuchtstoffen gemischt wird und so eine lichtkonvertierende Mischung bildet, die insbesondere weißes Licht oder Licht mit einem bestimmten Farbpunkt (Color-on-demand-Prinzip) emittiert. Unter "Color-on-demand-Prinzip" versteht man die Realisierung von Licht eines bestimmten Farbpunktes mit einer pc-LED unter Einsatz eines oder mehrerer lichtemittierender Materialien und/oder Konversionsleuchtstoffe.

Ein weiterer Gegenstand der vorliegenden Erfindung ist somit eine Lichtquelle, die eine Primärlichtquelle und mindestens ein erfindungsgemäßes lichtkonvertierendes Material oder mindestens eine erfindungsgemäße lichtkonvertierenden Mischung umfasst. Auch hier ist es insbesondere bevorzugt, dass die Lichtquelle neben dem erfindungsgemäßen lichtkonvertierenden Material noch ein weiteres erfindungsgemäßes lichtkonvertierendes Material und/oder einen Konversionsleuchtstoff umfasst, so dass die Lichtquelle vorzugsweise weißes Licht oder Licht mit einem bestimmten Farbpunkt emittiert.

Die erfindungsgemäße Lichtquelle ist vorzugsweise eine pc-LED, die eine Primärlichtquelle und ein lichtkonvertierendes Material oder eine lichtkonvertierende Mischung enthält. Das lichtkonvertierende Material oder die lichtkonvertierende Mischung wird vorzugsweise in Form einer Schicht ausgebildet, wobei die Schicht eine Vielzahl von Teilschichten umfassen kann, wobei jede der Teilschichten eine anderes lichtkonvertierendes Material oder eine andere lichtkonvertierende Mischung enthalten kann. Somit kann die Schicht entweder ein einziges lichtkonvertierendes Material oder eine einzige lichtkonvertierende Mischung oder eine Vielzahl von Teilschichten umfassen, wobei jede Teilschicht wiederum eine anderes lichtkonvertierendes Material oder eine andere lichtkonvertierende Mischung umfasst. Die Dicke der Schicht kann im Bereich von einigen Millimetern bis zu wenigen Mikrometern, vorzugsweise im Bereich zwischen 2 mm und 40 μm, liegen, je nach Teilchengröße des lichtkonvertierenden Materials bzw. der lichtkonvertierenden Mischung und der geforderten optischen Merkmale.

In einigen Ausführungsformen zur Modulation des Emissionsspektrums einer LED kann auf der Primärlichtquelle eine einzige Schicht oder eine Schicht mit Teilschichten gebildet werden. Die Schicht oder die Schicht mit Teilschichten kann entweder direkt auf der Primärlichtquelle angeordnet sein oder von der Primärlichtquelle durch Luft, Vakuum oder ein Füllmaterial beabstandet sein. Das Füllmaterial (beispielsweise Silicon oder Epoxy) kann als Wärmeisolierung und/oder als optische Streuschicht dienen. Die Modulation des Emissionsspektrums der Primärlichtquelle kann Beleuchtungszwecken dienen, um eine Lichtabgabe mit einem breiten Farbspektrum zu erzeugen, z.B. "weißes" Licht mit einem hohen Farbwiedergabeindex (color rendering index - CRI) und der gewünschten korrelierten Farbtemperatur (correlated color temperature - CCT). Die Lichtabgabe mit breitem Farbspektrum wird erzeugt, indem man einen Teil des ursprünglichen von der Primärlichtquelle erzeugten Lichtes in längerwelliges Licht umwandelt. Eine Verstärkung der Intensität von Rot ist wichtig, um "wärmeres" Licht mit niedrigerer CCT (z.B. 2700-3500K) zu erhalten, aber auch ein "Glätten" spezifischer Bereiche im Spektrum, wie beispielsweise im Übergang von blau auf grün, kann den CRI ebenfalls verbessern. Die Modulation der LED-Beleuchtung kann auch für optische Anzeigezwecke verwendet werden.

Das erfindungsgemäße lichtkonvertierende Material oder die erfindungsgemäße lichtkonvertierende Mischung kann in einem Vergussmaterial, wie beispielsweise einem Glas, Silicon- oder Epoxy-Harz, dispergiert sein oder als keramisches Material ausgebildet sein. Das Vergussmaterial ist ein lichtdurchlässiges Matrixmaterial, das das erfindungsgemäße lichtkonvertierende Material bzw. die erfindungsgemäße lichtkonvertierende Mischungen einschließt. Bevorzugte Beispiele des Vergussmaterials, die keineswegs als einschränkend zu verstehen sind, sind weiter oben genannt. Vorzugsweise wird das lichtkonvertierende Material oder die lichtkonvertierende Mischung in einem Verhältnis von 3 bis 80 Gew.-%, bezogen auf das Vergussmaterial, eingesetzt, je nach den gewünschten optischen Eigenschaften und dem Aufbau der Anwendung.

In einer bevorzugten Ausführungsform ist das erfindungsgemäße lichtkonvertierende Material oder die erfindungsgemäße lichtkonvertierende Mischung direkt auf der Primärlichtquelle angeordnet.

In einer alternativen bevorzugten Ausführungsform ist das erfindungsgemäße lichtkonvertierende Material oder die erfindungsgemäße lichtkonvertierende Mischung auf einem Trägermaterial von der Primärlichtquelle entfernt angeordnet (sog. Remote-Phosphor-Prinzip).

Die Primärlichtquelle der erfindungsgemäßen Lichtquelle kann ein Halbleiterchip, eine lumineszente Lichtquelle, wie ZnO, eine sogenanntes TCO (Transparent Conducting Oxide), eine ZnSe oder SiC basierende Anordnung, eine auf einer organischen Licht-emittierenden Schicht basierende Anordnung (OLED) oder eine Plasma- oder Entladungsquelle sein, am stärksten bevorzugt ein Halbleiterchip. Ist die Primärlichtquelle ein Halbleiterchip, so handelt es sich vorzugsweise um ein lumineszentes Indium-Aluminium-Gallium-Nitrid (InAlGaN), wie es im Stand der Technik bekannt ist. Dem Fachmann sind mögliche Formen von derartigen Primärlichtquellen bekannt. Weiterhin geeignet sind Laser als Lichtquelle.

Das erfindungsgemäße lichtkonvertierende Material oder die erfindungsgemäße lichtkonvertierende Mischung kann zum Einsatz in Lichtquellen, insbesondere pc-LEDs, in beliebigen äußeren Formen, wie beispielsweise sphärischen Partikeln, Plättchen sowie strukturierte Materialien und Keramiken, überführt werden. Diese Formen werden unter dem Begriff "Formkörper" zusammengefasst. Folglich handelt es sich bei den Formkörpern um lichtkonvertierende Formkörper.

Ein weiterer Gegenstand der vorliegenden Erfindung ist ein Verfahren zur Herstellung einer Lichtquelle, wobei das lichtkonvertierende Material oder die lichtkonvertierende Mischung in Form eines Films durch Spin-Coating oder Sprühbeschichtung oder in Form einer Folie als Laminat auf die Primärlichtquelle oder das Trägermaterial aufgebracht wird.

Ein weiterer Erfindungsgegenstand ist eine Beleuchtungseinheit, die mindestens eine erfindungsgemäße Lichtquelle enthält. Die Verwendung der Beleuchtungseinheit unterliegt keiner besonderen Einschränkung. So kann die Beleuchtungseinheit beispielsweise in optischen Anzeigevorrichtungen, insbesondere Flüssigkristallanzeigevorrichtungen (LC-Displays), mit einer Hintergrundbeleuchtung eingesetzt werden. Daher ist auch eine derartige Anzeigevorrichtung Gegenstand der vorliegenden Erfindung. In der erfindungsgemäßen Beleuchtungseinheit erfolgt die optische Ankopplung zwischen dem lichtkonvertierenden Material oder der lichtkonvertierenden Mischung und der Primärlichtquelle (insbesondere Halbleiterchips) vorzugsweise durch eine lichtleitende Anordnung oder Vorrichtung. Dadurch ist es möglich, dass an einem zentralen Ort die Primärlichtquelle installiert wird und diese mittels lichtleitender Vorrichtungen, wie beispielsweise lichtleitenden Fasern, an das lichtkonvertierende Material oder die lichtkonvertierende Mischung optisch angekoppelt ist. Auf diese Weise lassen sich den Beleuchtungswünschen angepasste Leuchten bestehend aus einem oder mehreren unterschiedlichen lichtkonvertierenden Materialien oder Mischungen, die zu einem Leuchtschirm angeordnet sein können, und einem Lichtleiter, der an die Primärlichtquelle angekoppelt ist, realisieren. Dadurch ist es möglich, eine starke Primärlichtquelle an einem für die elektrische Installation günstigen Ort zu platzieren und ohne weitere elektrische Verkabelung, nur durch Verlegung von Lichtleitern an beliebigen Orten, Leuchten aus lichtkonvertierenden Materialien oder Mischungen, die an die Lichtleiter gekoppelt sind, zu installieren.

Die folgenden Beispiele und Figuren sollen die vorliegende Erfindung verdeutlichen. Sie sind jedoch keinesfalls als einschränkend zu betrachten.

Beispiele

Alle Emissionsspektren wurden in einer Ulbricht'schen Kugel kombiniert mit einem OceanOptics HR 4000 Spektrometer aufgenommen. Als Anregungslichtquelle zur Aufnahme von Pulverspektren dient eine Halogen-Kaltlichtquelle mit Monochromator. Die getesteten LEDs werden mittels eines Keithley-Sourcemeters betrieben (für die hier gezeigten Versuche wurde die 3528 LED mit ~450nm Chipwellenlänge bei 20 mA verwendet).

Die Aufnahme der Korngrößenverteilungen wurde mit einem Beckman Coulter Multisizer III in isotonischer Kochsalzlösung vorgenommen. Es wurden jeweils >100.000 Teilchen vermessen.

Ausführungsbeispiele für die Herstellung des lichtkonvertierenden Materials

ROT:

**Beispiel 1:** 100 g eines weißen pulvrigen, unaktivierten Aluminats ($Y_3Al_5O_{12}$) werden in einem 500 ml Kolben in 150 ml Heptan suspendiert. Zur Suspension werden 33 ml einer roten Quantenrod-Lösung (3 Gew.-% CdSe/CdS-Nanostäbchen in Heptan, stabilisiert mit TOP, TOPO und ODPA) gegeben. Diese Suspension wird für 2 h ohne Vakuum bei RT gemischt. Am Rotationsverdampfer wird das Lösungsmittel unter Vakuum bei 40 °C Wasserbadtemperatur vorsichtig entfernt. Das beschichtete Granatpulver wird über Nacht getrocknet (Vakuum/25 °C). Abschließend wird das beschichtete System auf eine Korngröße von < 64 $\mu$m gesiebt.

**Beispiel 2:** 15 g eines weißen pulvrigen, unaktivierten Silikats ($Sr_3SiO_5$) werden in einem 250 ml Kolben in 100 ml Wasser suspendiert. Zur Suspension werden 4,5 ml einer roten Quantenrod-Lösung (3 Gew.-% CdSe/CdS-Nanostäbchen in Wasser, stabilisiert mit PEI) gegeben. Diese Suspension wird für 3h ohne Vakuum bei RT mittels Rotationsverdampfer bei 60 U/min gemischt. Eine bessere Homogenisierung wird durch die Zugabe von kleinen $Al_2O_3$-Kugeln gewährleistet. Am Rotationsverdampfer wird das Lösungsmittel unter Vakuum bei 40 °C Wasserbadtemperatur vorsichtig entfernt. Zur vollständigen Entfernung des Lösungsmittels wird das beschichtete Silikat für ca. 12 weitere Stunden unter Vakuum bei RT am Rotationsverdampfer belassen. Abschließend wird das beschichtete System auf eine Korngröße von < 64 $\mu$m gesiebt.

**Beispiel 3:** 10 g eines weißen pulvrigen, unaktivierten Titanats ($Mg_2TiO_4$) werden in einem 100 ml Kolben in 50 ml Toluol suspendiert. Zur Suspension werden 3 ml einer roten Quantenrod-Lösung (3 Gew.-% CdSe/CdS-Nanostäbchen in Toluol, stabilisiert mit TOP, TOPO und ODPA) gegeben. Diese Suspension wird für 3 h ohne Vakuum bei RT gerührt. Anschließend wird das beschichtete Titanat über einer Fritte abgesaugt und zur vollständigen Trocknung über Nacht unter Vakuum bei RT stehen gelassen. Abschließend wird das beschichtete System auf eine Korngröße von < 64 $\mu$m gesiebt.

GRÜN:

**Beispiel 4:** 15 g eines weißen pulvrigen, unaktivierten Aluminats ($Y_3Al_5O_{12}$) werden in einem 500 ml Kolben in 80 ml Heptan suspendiert. Zur Suspension werden 4,5 ml einer grünen Quantenrod-Lösung (3-Gew.-% CdSe/CdS-Nanostäbchen in Heptan, stabilisiert mit TOP, TOPO und ODPA) gegeben. Diese Suspension wird für 2h ohne Vakuum bei RT mittels Rotationsverdampfer bei 60 U/min gemischt. Eine bessere Homogenisierung wird durch die Zugabe von kleinen Al2O$_3$-Kugeln gewährleistet. Am Rotationsverdampfer wird das Lösungsmittel unter Vakuum bei 40 °C Wasserbadtemperatur vorsichtig entfernt. Zur vollständigen Entfernung des Lösungsmittels wird der beschichtete Granat über Nacht unter Vakuum bei RT getrocknet. Abschließend wird das beschichtete System auf eine Korngröße von < 64 $\mu$m gesiebt.

Vermessung der hergestellten lichtkonvertierenden Materialien

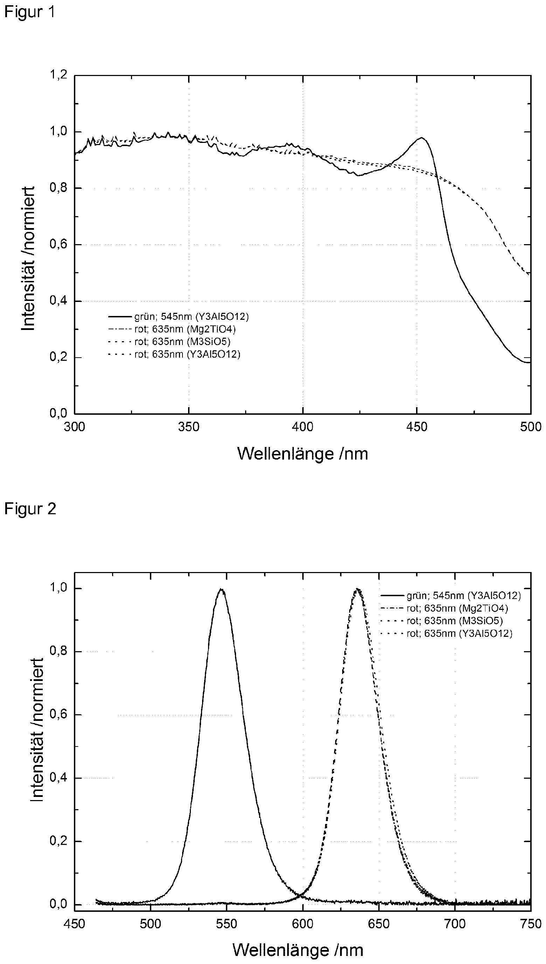

Von allen anfallenden lichtkonvertierenden Materialien wurde die relative spektrale Energieverteilung mittels eines Faseroptikspektrometers bei einer Anregungswellenlänge von 450 nm aufgenommen. Weiterhin wurde die Absorption bei unterschiedlichen Anregungswellenlängen bestimmt. Absorptionsspektren aller hergestellten lichtkonvertierenden Materialien sind in Figur 1 gezeigt. Die relative spektrale Energieverteilung aller hergestellten Materialien (Emission) ist in Figur 2 gezeigt.

LED-Evaluierung

Unbefüllte LEDs werden mit einem optischen Silicon (Dow Corning OE6550), in welchem genaue Mengen von roten und grünen Partikeln suspendiert sind, über einen Dispenser befüllt. Die Siliconsuspension wird mittels eines biaxialen Rotationsmischers hergestellt und folgend unter Vakuum entgast. Anschließend wird die LED im Trockenschrank bei 140°C für 5 h ausgehärtet und mittels einer Ulbricht'schen Kugel mit Faseroptikspektrometer hinsichtlich der resultierenden Lichtemission vermessen. Durch Variation der Gesamtmenge des Pulvers im Silicon wie auch der roten, gelben oder grünen Einzelkomponenten kann nahezu jeder Farbort im Farbdreieck erreicht werden.

Anstelle von Silicon können auch andere hochtransparente Materialien als Vergussmasse, zum Beispiel Epoxidharze, verwendet werden.

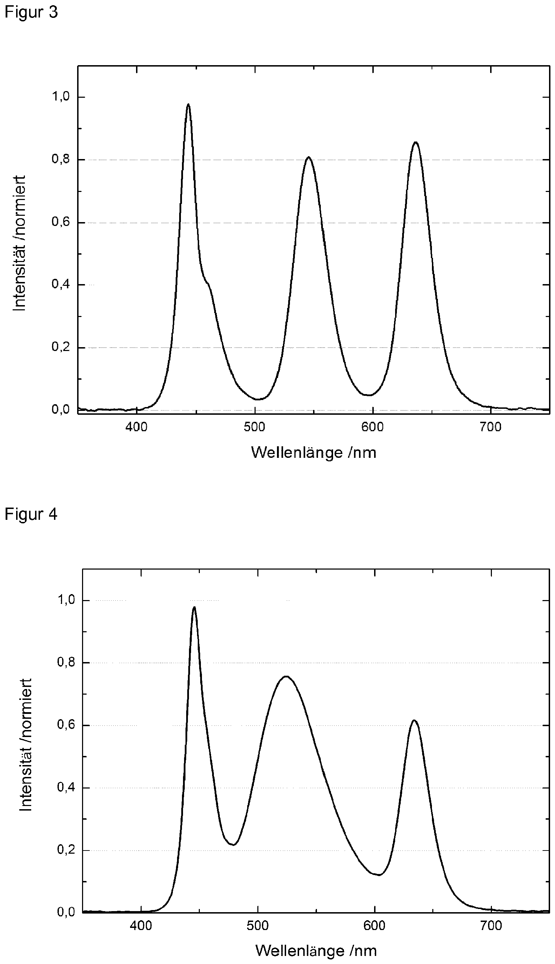

**LED 1:** roter QD ($\lambda_{max}$=635 nm) auf $Sr_3SiO_5$ kombiniert mit grünem QD ($\lambda_{max}$=543 nm) auf $Y_3Al_5O_{12}$ in einer blauen LED ($\lambda_{max}$=450 nm) bei Farbkoordinate x~0,31 und y~0,31; NTSC mit Standardfarbfilter ist 100%. Figur 3 zeigt das Emissionsspektrum der LED 1.

**LED 2:** roter QD ($\lambda_{max}$=635 nm) auf $Sr_3SiO_5$ kombiniert mit grünem Silikatleuchtstoff ($\lambda_{max}$=520 nm) in einer blauen LED ($\lambda_{max}$=450 nm) bei Farbkoordinate x~0,31 und y~0,31; NTSC mit Standardfarbfilter ist 98%. Figur 4 zeigt das Emissionsspektrum der LED 2.

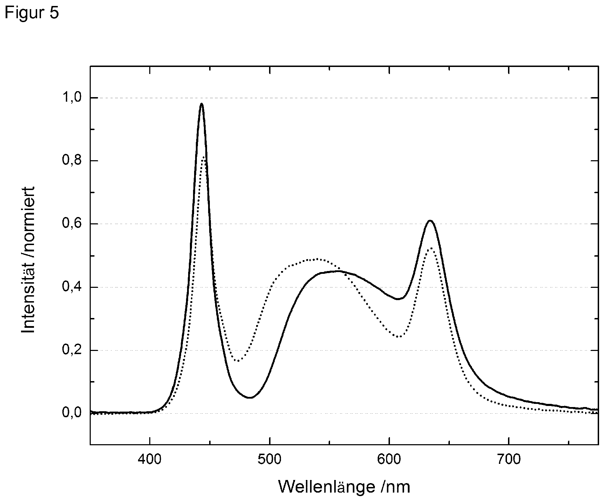

**LED 3:** roter QD ($\lambda_{max}$=635nm) auf $Y_3Al_5O_{12}$ in einer Mischung mit grünem $Lu_3Al_5O_{12}$:Ce ($\lambda_{max}$=540 nm, CRI 85, dotted line) und in einer Mischung mit gelbem $Y_3Al_5O_{12}$:Ce ($\lambda_{max}$=560 nm, CRI 80, solid line). Figur 5 zeigt das Emissionsspektrum der LED 3.

Weitere nützliche Vorteile der erfindungsgemäßen lichtkonvertierenden Materialien:

- NTSC mit Standardfarbfilter in herkömmlicher 450nm LED, grünem Leuchtstoff β-Sialon535 und rotem Leuchtstoff $K_2SiF_6$ erlangt nur 94%.

- Gleiches Sedimentationsverhalten über alle in der LED verwendeten Konversionsmaterialien gegeben, ggf. gezielt einstellbar und erhöhte Produktionsausbeute im LED-Herstellprozess.

- Wenig Reabsorption im grünen/gelben Spektralbereich, damit weniger Doppelkonversion und erhöhte Effizienzen sowie bessere Vorhersagbarkeit des LED-Spektrums.

- Einfach zu verwenden, da kein neues Produktionsequipment beim LED-Hersteller benötigt wird.

- Anwender hat mehr Möglichkeiten die LED-Emission einzustellen im Vergleich zu herkömmlichen QD-Filmen bzw. QD auf aktivierten Leuchtstoffen (flexibler Einsatz, da Anwender nicht für jeden Farbort einen anderen Lichtkonverter verwenden muss).

- Erhöhte Helligkeit der LED, da die rote, schmalbandige Emission keine Energie im tiefen langwelligen Spektralbereich mit geringer Augenempfindlichkeit verschwendet.

- Vorhandene Coating-Technologien für Leuchtstoffe können angewendet werden; es sind keine zusätzlichen Barrierefilme notwendig.

Ausführungsformen der vorliegenden Erfindung:

[1] Lichtkonvertierendes Material, umfassend Halbleiter-Nanopartikel und ein unaktiviertes kristallines Material, wobei sich die Halbleiter-Nanopartikel auf der Oberfläche des unaktivierten kristallinen Materials befinden.

[2] Lichtkonvertierendes Material gemäß [1], dadurch gekennzeichnet, dass das unaktivierte kristalline Material ein Matrixmaterial eines anorganischen Leuchtstoffes ist, ausgewählt aus der Liste bestehend aus unaktivierten kristallinen Metalloxiden, unaktivierten kristallinen Silikaten und Halosilikaten, unaktivierten kristallinen Phosphaten und Halophosphaten, unaktivierten kristallinen Boraten und Borosilikaten, unaktivierten kristallinen Aluminaten, Gallaten und Alumosilikaten, unaktivierten kristallinen Molybdaten und Wolframaten, unaktivierten kristallinen Sulfaten, Sulfiden, Seleniden und Telluriden, unaktivierten kristallinen Nitriden und Oxynitriden, unaktivierten kristallinen SiAlONen und anderen unaktivierten kristallinen Materialien, ausgewählt aus unaktivierten kristallinen komplexen Metall-Sauerstoff-Verbindungen, unaktivierten kristallinen Halogen-Verbindungen und unaktivierten kristallinen Oxy-Verbindungen, wie vorzugsweise Oxysulfiden oder Oxychloriden.

[3] Lichtkonvertierendes Material gemäß [2], dadurch gekennzeichnet, dass das unaktivierte kristalline Metalloxid ausgewählt ist aus der Liste bestehend aus $M^{2+}O$, $M^{3+}_2O_3$ und $M^{4+}O_2$; wobei $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Ga, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; und $M^{4+}$ Ti, Zr, Ge, Sn und/oder Th ist.

[4] Lichtkonvertierendes Material gemäß [2] oder [3], dadurch gekennzeichnet, dass das unaktivierte kristalline Silikat oder Halosilikat ausgewählt ist aus der Liste bestehend aus $M^{2+}SiO_3$, $M^{2+}_2SiO_4$, $M^{2+}_2(Si,Ge)O_4$, $M^{2+}_3SiO_5$, $M^{3+}_2SiO_5$, $M^{3+}M^+SiO_4$, $M^{2+}Si_2O_5$, $M^{2+}_2Si_2O_6$, $M^{2+}_3Si_2O_7$, $M^{2+}_2M^+_2Si_2O_7$, $M^{3+}_2Si_2O_7$, $M^{2+}_4Si_2O_8$, $M^{2+}_2Si_3O_8$, $M^{2+}_3M^{3+}_2Si_3O_{12}$, $M^+M^{3+}M^{2+}_4Si_4O_{10}$, $M^+M^{2+}_4M^{3+}Si_4O_{14}$, $M^{2+}_3M^{3+}_2Si_6O_{18}$, $M^{3+}SiO_3X$, $M^{2+}_3SiO_4X_2$, $M^{2+}_5SiO_4X_6$, $M^+_2M^{2+}_2Si_4O_{10}X_2$, $M^{2+}_5Si_4O_{10}X_6$, $M^+_2SiX_6$, $M^{2+}_3SiO_3X_4$ und $M^{2+}_9(SiO_4)_4X_2$; wobei $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; und X ein oder mehrere Halogene, vorzugsweise F, Cl, Br und/oder I, ist.

[5] Lichtkonvertierendes Material gemäß einem oder mehreren von [2] bis [4], dadurch gekennzeichnet, dass das unaktivierte kristalline Phosphat oder Halophosphat ausgewählt ist aus der Liste bestehend aus $M^{3+}PO_4$, $M^{2+}P_2O_6$, $M^{2+}_2P_2O_7$, $M^+_2M^{2+}P_2O_7$, $M^{4+}P_2O_7$, $M^{2+}B_2P_2O_9$, $M^{2+}_6BP_5O_{20}$, $M^{2+}_3(PO_4)_2$, $M^+_3M^{3+}(PO_4)_2$, $M^{2+}_6(PO_4)_4$ und $M1^{2+}_5(PO_4)_3X$; wobei $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; $M^{4+}$ Ti, Zr, Ge und/oder Sn ist; und X ein oder mehrere Halogene, vorzugsweise F, Cl, Br und/oder I, ist.

[6] Lichtkonvertierendes Material gemäß einem oder mehreren von [2] bis [5], dadurch gekennzeichnet, dass das unaktivierte kristalline Borat, Haloborat oder Borosilikat ausgewählt ist aus der Liste bestehend aus $M^{3+}BO_3$, $M^{2+}B_2O_4$, $M^{2+}_2B_2O_5$, $M^{3+}_2B_2O_6$, $M^{3+}B_3O_6$, $M^{2+}B_6O_{10}$, $M^{2+}M^{3+}BO_4$, $M^{2+}M^{3+}B_3O_7$, $M^{2+}B_4O_7$, $M^{2+}_3M^{3+}_2B_4O_{12}$, $M^{3+}_4B_4O_{12}$, $M^{3+}M^{2+}B_5O_{10}$, $M^{2+}_2B_6O_{11}$, $M^{2+}B_8O_{13}$, $M^{2+}_2B_5O_9X$, $M^{2+}_2M^{3+}_2BO_{6,5}$, $M^{2+}_5B_2SiO_{10}$; wobei $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Ga, In, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; und X ein oder mehrere Halogene, vorzugsweise F, Cl, Br und/oder I, ist.

[7] Lichtkonvertierendes Material gemäß einem oder mehreren von [2] bis [6], dadurch gekennzeichnet, dass das unaktivierte kristalline Aluminat, Gallat oder Alumosilikat ausgewählt ist aus der Liste bestehend aus $M^+AlO_2$, $M^{3+}AlO_3$, $M^{2+}M^{3+}AlO_4$, $M^{2+}Al_2O_4$, $M^{2+}Al_4O_7$, $M^+Al_5O_8$, $M^{3+}_4Al_2O_9$, $M^{3+}_3Al_5O_{12}$, $M^+Al_{11}O_{17}$, $M^{2+}_2Al_{10}O_{17}$, $M^{3+}_3Al_5O_{12}$, $M^{3+}_3(Al,Ga)_5O_{12}$, $M^{3+}_3Sc_2Al_3O_{12}$, $M^{2+}_2Al_6O_{11}$, $M^{2+}Al_8O_{13}$, $M^{2+}M^{3+}Al_{11}O_{19}$, $M^{2+}Al_{12}O_{19}$, $M^{2+}_4Al_{14}O_{25}$, $M^{2+}_3Al_{16}O_{27}$, $M^{2+}Ga_2O_4$, $M^{2+}Ga_4O_7$, $M^{3+}_3Ga_5O_{12}$, $M^+Ga_{11}O_{17}$, $M^{2+}Ga_{12}O_{19}$, $M^+_2M^{2+}_3Al_2Si_2O_{10}$ und $M^{2+}_3Al_2Si_3O_{12}$, wobei $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; und X ein oder mehrere Halogene, vorzugsweise F, Cl, Br und/oder I, ist.

[8] Lichtkonvertierendes Material gemäß einem oder mehreren von [2] bis [7], dadurch gekennzeichnet, dass das unaktivierte kristalline Molybdat oder Wolframat ausgewählt ist aus der Liste bestehend aus $M^{2+}MoO_4$, $M^+M^{3+}MO_2O_8$, $M^{2+}WO_4$, $M^{2+}_3WO_6$, $M^{3+}_2W_3O_{12}$, $M^+M^{3+}W_2O_8$, wobei $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; und X ein oder mehrere Halogene, vorzugsweise F, Cl, Br und/oder I, ist.

[9] Lichtkonvertierendes Material gemäß einem oder mehreren von [2] bis [8], dadurch gekennzeichnet, dass die unaktivierte kristalline komplexe Metall-Sauerstoff-Verbindung ausgewählt ist aus der Liste bestehend aus $M^{3+}AsO_4$, $M^{2+}_{13}As_2O_{18}$, $M^{2+}GeO_3$, $M^{2+}_2GeO_4$, $M^{2+}_4GeO_6$, $M^{2+}_4(Ge,Sn)O_6$, $M^{2+}_2Ge_2O_6$, $M^{3+}_4Ge_3O_{12}$, $M^{2+}_5GeO_4X_6$, $M^{2+}_8Ge_2O_{11}X_2$, $M^+InO_2$, $M^{2+}In_2O_4$, $M^+LaO_2$, $M^{2+}La_4O_7$, $M^{3+}NbO_4$, $M^{2+}Sc_2O_4$, $M^{2+}_2SnO_4$, $M^{3+}TaO_4$, $M^{2+}TiO_3$, $M^{2+}_2TiO_4$, $M^+_2M^{3+}_2Ti_3O_{10}$, $M^{2+}_5(VO_4)_3X$, $M^{3+}VO_4$, $M^{3+}(V,P)O_4$, $M^+YO_2$, $M^{2+}ZrO_3$, $M^{2+}_2ZrO_4$ und $M^{2+}M^{3+}_2ZrO_6$; wobei $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La, Bi und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; $M^{4+}$ Ti, Zr, Ge und/oder Sn ist; und X ein oder mehrere Halogene, vorzugsweise F, Cl, Br und/oder I, ist.

[10] Lichtkonvertierendes Material gemäß einem oder mehreren von [2] bis [9], dadurch gekennzeichnet, dass das unaktivierte kristalline Sulfat, Sulfid, Selenid oder Tellurid ausgewählt ist aus der Liste bestehend aus $M^{2+}SO_4$, $M^{2+}_2(SO_4)_2$, $M^{3+}_3(SO_4)_3$, $M^{3+}_2(SO_4)_3$, $M^{2+}S$, $M^{2+}(S,T_e)$, $M^{2+}Se$, $M^{2+}Te$, $M^{2+}Ga_2S_4$, $M^{2+}Ba_2S_3$ und $M^{2+}Al_2S_4$; wobei $M^{2+}$ Zn, Fe, Co, Ni, Cd, Cu und/oder ein oder mehrere Erdalkalimetalle, vorzugsweise Be, Mg, Ca, Sr und/oder Ba, ist; und $M^{3+}$ Al, Sc, Y, La, und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist.

[11] Lichtkonvertierendes Material gemäß einem oder mehreren von [2] bis [10], dadurch gekennzeichnet, dass die unaktivierte kristalline Halogen- oder Oxy-Verbindung ausgewählt ist aus der Liste bestehend aus $M^+X$, $M^{2+}X_2$, $M^{3+}X_3$, $M^+M^{2+}X_3$, $M^+M^{3+}X_4$, $M^{2+}M^{3+}_2X_8$, $M^+M^{3+}_3X_{10}$, $M^{3+}OX$, $M^{2+}_8M^{4+}_2O_{11}X_2$ und $M^{3+}_2O_2S$; wobei $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La, und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; und X ein oder mehrere Halogene, vorzugsweise F, Cl, Br und/oder I, ist.

[12] Lichtkonvertierendes Material gemäß einem oder mehreren von [2] bis [11], dadurch gekennzeichnet, dass das unaktivierte kristalline Nitrid, Oxynitrid oder SiAlON ausgewählt ist aus der Liste bestehend aus $M^{3+}N$, $M^{2+}Si_2O_2N_2$, $M^{2+}_2Si_5N_8$, $M^{3+}_3Si_6N_{11}$, $M^{2+}AlSiN_3$, $\alpha$-Sialonen und $\beta$-Sialonen; wobei $M^{2+}$ Zn, Fe, Co, Ni, Cd, Cu und/oder ein oder mehrere Erdalkalimetalle, vorzugsweise Be, Mg, Ca, Sr und/oder Ba, ist; und $M^{3+}$ Al, Ga, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist.

[13] Lichtkonvertierendes Material gemäß einem oder mehreren von [1] bis [12], dadurch gekennzeichnet, dass die Halbleiter-Nanopartikel aus mindestens zwei verschiedenen Halbleitermaterialien in einer Legierung, in einer Kern-Schale-Konfiguration oder in einer Kern-Mehrschalen-Konfiguration mit mindestens zwei Schalen bestehen, wobei der Kern entweder ein Halbleitermaterial oder eine Legierung aus mindestens zwei verschiedenen Halbleitermaterialien umfasst und die Schale(n) unabhängig ein Halbleitermaterial oder eine Legierung aus mindestens zwei verschiedenen Halbleitermaterialien umfassen, wobei wahlweise ein Konzentrationsgradient innerhalb des Kerns und/oder der Schale(n) und/oder zwischen dem Kern und/oder den Schale(n) vorliegen kann.

[14] Lichtkonvertierendes Material gemäß einem oder mehreren von [1] bis [13], dadurch gekennzeichnet, dass die Halbleitermaterialien ausgewählt sind aus Gruppe II-VI-Halbleitern, Gruppe III-V-Halbleitern, Gruppe IV-VI-Halbleitern, Gruppe I-III-VI$_2$-Halbleitern sowie aus Legierungen und/oder Kombinationen dieser Halbleiter, wobei die Halbleitermaterialien wahlweise mit einem oder mehreren Übergangsmetallen dotiert sein können.

[15] Lichtkonvertierendes Material gemäß einem oder mehreren von [1] bis [14], dadurch gekennzeichnet, dass die Halbleiter-Nanopartikel in Form von Nanopunkten, Nanostäbchen, Nanoplättchen, Nanotetrapods, Nanopunkten in Nanostäbchen, Nanostäbchen in Nanostäbchen und/oder Nanopunkten in Nanoplättchen vorliegen.

[16] Lichtkonvertierendes Material gemäß einem oder mehreren von [1] bis [15], dadurch gekennzeichnet, dass die Oberfläche des lichtkonvertierenden Materials mit einem oder mehreren Beschichtungsmaterialien beschichtet ist.

[17] Lichtkonvertierende Mischung, umfassend eines oder mehrere der lichtkonvertierenden Materialien gemäß einem oder mehreren von [1] bis [16].

[18] Verwendung eines lichtkonvertierenden Materials gemäß einem von [1] bis [16] oder einer lichtkonvertierenden Mischung gemäß [17] zur teilweisen oder vollständigen Konversion von ultraviolettem und/oder blauem Licht in Licht mit einer größeren Wellenlänge.

[19] Lichtquelle, enthaltend mindestens eine Primärlichtquelle und mindestens ein lichtkonvertierendes Material gemäß einem von [1] bis [16] oder eine lichtkonvertierende Mischung gemäß [17].

[20] Lichtquelle gemäß [19], dadurch gekennzeichnet, dass das lichtkonvertierende Material oder die lichtkonvertierende Mischung direkt auf der Primärlichtquelle angeordnet ist oder auf einem Trägermaterial von der Primärlichtquelle entfernt angeordnet ist.

[21] Verfahren zur Herstellung einer Lichtquelle gemäß [19] oder [20], wobei das lichtkonvertierende Material oder die lichtkonvertierende Mischung in Form eines Films durch Spin-Coating oder Sprühbeschichtung oder in Form einer Folie als Laminat auf die Primärlichtquelle oder das Trägermaterial aufgebracht wird.

[22] Beleuchtungseinheit, enthaltend mindestens eine Lichtquelle gemäß [19] oder [20].

**Patentansprüche**

1. Lichtkonvertierendes Material, umfassend Halbleiter-Nanopartikel und ein unaktiviertes kristallines Material, wobei sich die Halbleiter-Nanopartikel auf der Oberfläche des unaktivierten kristallinen Materials befinden und das unaktivierte kristalline Material ein Matrixmaterial eines anorganischen Leuchtstoffes ist, **dadurch gekennzeichnet, dass** die Oberfläche der Halbleiter-Nanopartikel mit einem oder mehreren Liganden beschichtet ist.

2. Lichtkonvertierendes Material gemäß Anspruch 1, **dadurch gekennzeichnet, dass** das unaktivierte kristalline Material ein Matrixmaterial eines anorganischen Leuchtstoffes ist, ausgewählt aus der Liste bestehend aus unaktivierten kristallinen Metalloxiden, unaktivierten kristallinen Silikaten und Halosilikaten, unaktivierten kristallinen Phosphaten und Halophosphaten, unaktivierten kristallinen Boraten und Borosilikaten, unaktivierten kristallinen Aluminaten, Gallaten und Alumosilikaten, unaktivierten kristallinen Molybdaten und Wolframaten, unaktivierten kristallinen Sulfaten, Sulfiden, Seleniden und Telluriden, unaktivierten kristallinen Nitriden und Oxynitriden, unaktivierten kristallinen SiAlONen und anderen unaktivierten kristallinen Materialien, ausgewählt aus unaktivierten kristallinen komplexen Metall-Sauerstoff-Verbindungen, unaktivierten kristallinen Halogen-Verbindungen und unaktivierten kristallinen Oxy-Verbindungen, wie vorzugsweise Oxysulfiden oder Oxychloriden.

3. Lichtkonvertierendes Material gemäß Anspruch 1 oder 2, **dadurch gekennzeichnet, dass** die Liganden ausgewählt sind aus der Liste bestehend aus Phosphinen, Phosphinoxiden, Phosphonsäuren, Aminen, Thiolen, Mercaptocarbonsäuren und anderen Säuren.

4. Lichtkonvertierendes Material gemäß einem oder mehreren der Ansprüche 1 bis 3, **dadurch gekennzeichnet, dass** die Liganden ausgewählt sind aus der Liste bestehend aus Trioctylphosphinoxid (TOPO), Trioctylphosphin (TOP), Tributylphosphin (TBP), Dodecylphosphonsäure (DDPA), Tridecylphosphonsäure (TBPA), Octadecylphosphonsäure (ODPA), Hexylphosphonsäure (HPA), Dodecylamin (DDA), Tetradecylamin (TDA), Hexadecylamin (HDA), Octadecylamin (ODA), Hexadecanthiol, Hexanthiol, Mercaptopropionsäure, Mercaptoundecansäure, Myristinsäure, Palmitinsäure und Ölsäure.

5. Lichtkonvertierendes Material gemäß einem oder mehreren der Ansprüche 1 bis 4, **dadurch gekennzeichnet, dass** die Halbleiter-Nanopartikel aus mindestens zwei verschiedenen Halbleitermaterialien in einer Legierung, in einer Kern-Schale-Konfiguration oder in einer Kern-Mehrschalen-Konfiguration mit mindestens zwei Schalen bestehen, wobei der Kern entweder ein Halbleitermaterial oder eine Legierung aus mindestens zwei verschiedenen Halbleitermaterialien umfasst und die Schale(n) unabhängig ein Halbleitermaterial oder eine Legierung aus mindestens zwei verschiedenen Halbleitermaterialien umfassen, wobei wahlweise ein Konzentrationsgradient innerhalb des Kerns und/oder der Schale(n) und/oder zwischen dem Kern und/oder den Schale(n) vorliegen kann.

6. Lichtkonvertierendes Material gemäß einem oder mehreren der Ansprüche 1 bis 5, **dadurch gekennzeichnet, dass** die Halbleitermaterialien ausgewählt sind aus Gruppe II-VI-Halbleitern, Gruppe III-V-Halbleitern, Gruppe IV-VI-Halbleitern, Gruppe I-III-VI$_2$-Halbleitern sowie aus Legierungen und/oder Kombinationen dieser Halbleiter, wobei die Halbleitermaterialien wahlweise mit einem oder mehreren Übergangsmetallen dotiert sein können.

7. Lichtkonvertierendes Material gemäß einem oder mehreren der Ansprüche 1 bis 6, **dadurch gekennzeichnet, dass** die Halbleiter-Nanopartikel in Form von Nanopunkten, Nanostäbchen, Nanoplättchen, Nanotetrapods, Nanopunkten in Nanostäbchen, Nanostäbchen in Nanostäbchen und/oder Nanopunkten in Nanoplättchen vorliegen.

8. Lichtkonvertierendes Material gemäß einem oder mehreren der Ansprüche 1 bis 7, **dadurch gekennzeichnet, dass** die Oberfläche des lichtkonvertierenden Materials mit einem oder mehreren Beschichtungsmaterialien beschichtet ist.

9. Lichtkonvertierendes Material gemäß Anspruch 8, **dadurch gekennzeichnet, dass** das eine oder die mehreren Beschichtungsmaterialien ausgewählt sind aus der Liste bestehend aus Metalloxiden, Metallnitriden, Siliciumdioxid-basierten Materialien, (Poly)silazanen, organische Silanen und organischen Polymeren.

10. Lichtkonvertierende Mischung, umfassend eines oder mehrere der lichtkonvertierenden Materialien gemäß einem oder mehreren der Ansprüche 1 bis 9.

11. Verwendung eines lichtkonvertierenden Materials gemäß einem der Ansprüche 1 bis 9 oder einer lichtkonvertierenden Mischung gemäß Anspruch 10 zur teilweisen oder vollständigen Konversion von ultraviolettem und/oder blauem Licht in Licht mit einer größeren Wellenlänge.

12. Lichtquelle, enthaltend mindestens eine Primärlichtquelle und mindestens ein lichtkonvertierendes Material gemäß einem der Ansprüche 1 bis 9 oder eine lichtkonvertierende Mischung gemäß Anspruch 10.

13. Lichtquelle gemäß Anspruch 12, **dadurch gekennzeichnet, dass** das lichtkonvertierende Material oder die lichtkonvertierende Mischung direkt auf der Primärlichtquelle angeordnet ist oder auf einem Trägermaterial von der Primärlichtquelle entfernt angeordnet ist.

14. Verfahren zur Herstellung einer Lichtquelle gemäß Anspruch 12 oder 13, wobei das lichtkonvertierende Material oder die lichtkonvertierende Mischung in Form eines Films durch Spin-Coating oder Sprühbeschichtung oder in Form einer Folie als Laminat auf die Primärlichtquelle oder das Trägermaterial aufgebracht wird.

15. Beleuchtungseinheit, enthaltend mindestens eine Lichtquelle gemäß Anspruch 12 oder 13.

Figur 1

Figur 2

Figur 3

Figur 4

Figur 5

**Europäisches Patentamt**
**European Patent Office**
**Office européen des brevets**

# EUROPÄISCHER RECHERCHENBERICHT

**Nummer der Anmeldung**

EP 19 21 0815

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 1 516 944 A1 (SAMSUNG ELECTRONICS CO LTD [KR]) 23. März 2005 (2005-03-23) | 1-8,10 | INV. C09K11/02 |
| A | * Absätze [0044] - [0045] * | 9,11-15 | C09K11/56 C09K11/88 |
| | ----- | | H01L33/50 |
| X | EP 2 319 613 A1 (CONSEJO SUPERIOR INVESTIGACION [ES]) 11. Mai 2011 (2011-05-11) | 1,2,7,10 | B82Y30/00 |
| A | * Absätze [0036], [0037]; Abbildung 5 * | 3-6,8,9, 11-15 | |
| | ----- | | |
| X | EP 1 401 551 B1 (UNIV STRATHCLYDE [GB]) 21. Juni 2006 (2006-06-21) | 1-3,6-10 | |
| A | * Absätze [0051] - [0055] * | 4,5, 11-15 | |
| | ----- | | |
| X | DE 10 2012 110668 A1 (OSRAM OPTO SEMICONDUCTORS GMBH [DE]) 8. Mai 2014 (2014-05-08) * Ansprüche 1,13,14,19 * | 1-15 | |
| | ----- | | RECHERCHIERTE SACHGEBIETE (IPC) |
| A | EP 1 741 484 A1 (SAMSUNG ELECTRONICS CO LTD [KR]) 10. Januar 2007 (2007-01-10) * Absätze [0069] - [0071] * | 1-15 | C09K H01L B82Y |
| | ----- | | |
| A | DE 10 2011 082774 A1 (UNIV DRESDEN TECH [DE]) 22. März 2012 (2012-03-22) * Anspruch 1 * | 1-15 | |
| | ----- | | |

Der vorliegende Recherchenbericht wurde für alle Patentansprüche erstellt

| Recherchenort | Abschlußdatum der Recherche | Prüfer |
|---|---|---|
| Den Haag | 27. Februar 2020 | Pötzsch, Robert |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 19 21 0815

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

27-02-2020

| Im Recherchenbericht angeführtes Patentdokument | Datum der Veröffentlichung | Mitglied(er) der Patentfamilie | Datum der Veröffentlichung |
|---|---|---|---|
| EP 1516944 A1 | 23-03-2005 | CN 1595673 A | 16-03-2005 |
| | | CN 101974335 A | 16-02-2011 |
| | | EP 1516944 A1 | 23-03-2005 |
| | | EP 2284296 A1 | 16-02-2011 |
| | | JP 4928071 B2 | 09-05-2012 |
| | | JP 2005101601 A | 14-04-2005 |
| | | KR 20050026227 A | 15-03-2005 |
| | | US 2005051769 A1 | 10-03-2005 |
| EP 2319613 A1 | 11-05-2011 | BR PI0911023 A2 | 11-10-2016 |
| | | CN 102099100 A | 15-06-2011 |
| | | DK 2319613 T3 | 04-09-2017 |
| | | EP 2319613 A1 | 11-05-2011 |
| | | ES 2332079 A1 | 25-01-2010 |
| | | JP 5667562 B2 | 12-02-2015 |
| | | JP 2011530394 A | 22-12-2011 |
| | | KR 20110040945 A | 20-04-2011 |
| | | RU 2011106377 A | 27-08-2012 |
| | | US 2012107405 A1 | 03-05-2012 |
| | | WO 2010010220 A1 | 28-01-2010 |
| EP 1401551 B1 | 21-06-2006 | DE 60212628 T2 | 14-06-2007 |
| | | EP 1401551 A1 | 31-03-2004 |
| | | US 2004219221 A1 | 04-11-2004 |
| | | WO 03002225 A1 | 09-01-2003 |
| DE 102012110668 A1 | 08-05-2014 | DE 102012110668 A1 | 08-05-2014 |
| | | DE 112013005312 A5 | 23-07-2015 |
| | | US 2015255688 A1 | 10-09-2015 |
| | | WO 2014072255 A1 | 15-05-2014 |
| EP 1741484 A1 | 10-01-2007 | EP 1741484 A1 | 10-01-2007 |
| | | JP 2007016317 A | 25-01-2007 |
| | | KR 20070005452 A | 10-01-2007 |
| | | TW 200702464 A | 16-01-2007 |
| | | US 2007007511 A1 | 11-01-2007 |
| DE 102011082774 A1 | 22-03-2012 | DE 102011082774 A1 | 22-03-2012 |
| | | WO 2012035109 A1 | 22-03-2012 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7102152 B
- US 7495383 B
- US 7318651 B
- WO 2010095140 A3
- US 20150014728 A1
- WO 2005075339 A
- WO 2006134599 A
- EP 2528989 B1
- US 8062421 B2
- WO 2011092646 A2
- WO 2014140936 A
- JP 4304290 A
- WO 9110715 A
- WO 9927033 A
- US 20070298250 A
- WO 2009065480 A
- WO 2010075908 A

**In der Beschreibung aufgeführte Nicht-Patentliteratur**

- **Z. LIU et al.** Status and prospects for phosphor-based white LED Packaging. *Xiaobing Front. Optoelectron,* 2009, vol. 2 (2), 119-140
- **JOSEPH R. LAKOWICZ.** Principles of Fluorescence Spectroscopy. Kluwer Academic / Plenum Publishers, 1999, 367-443
- **X. PENG et al.** Shape control of CdSe nanocrystals. *Nature,* 2000, vol. 404, 59-61
- **T. MOKARI ; U. BANIN.** Synthesis andproperties of CdSe/ZnS rod/shell nanocrystals. *Chemistry of Materials,* 2003, vol. 15 (20), 3955-3960
- **D. V. TALAPIN et al.** Seeded Growth of Highly Luminescent CdSe/CdS Nanoheterostructures with Rod and Tetrapod Morphologies. *Nano Letters,* 2007, vol. 7 (10), 2951-2959
- **C. CARBONE et al.** Synthesis and Micrometer-Scale Assembly of Colloidal CdSe/CdS Nanorods Prepared by a Seeled Growth Approach. *Nano Letters,* 2007, vol. 7 (10), 2942-2950
- **BANIN et al.** *Adv. Mater.,* 2002, vol. 14, 317
- **BANIN et al.** *Nano Letters,* 2005, vol. 5, 1581
- **JAN ZIEGLER et al.** Silica-Coated InP/ZnS Nanocrystals as Converter Material in White LEDs. *Advanced Materials,* 13. Oktober 2008, vol. 20 (21), 4068-4073
- **M. J. ANC ; N. L. PICKETT et al.** *ECS Journal of Solid State Science and Technology,* 2013, vol. 2 (2), R3071-R3082